(19) Europäisches Patentamt
European Patent Office
Office européen des brevets

(11) EP 4 439 409 B1

# (12) EUROPEAN PATENT SPECIFICATION

(45) Date of publication and mention of the grant of the patent:
**09.09.2026 Bulletin 2026/37**

(21) Application number: **22895945.8**

(22) Date of filing: **07.11.2022**

(51) International Patent Classification (IPC):
***G06N 20/20*** *(2019.01)* ***H03M 7/30*** *(2006.01)*
***G06N 3/098*** *(2023.01)*

(52) Cooperative Patent Classification (CPC):
**H04B 17/309; G06N 3/006; G06N 3/044; G06N 3/045; G06N 3/063; G06N 3/08; G06N 3/084; G06N 3/088; G06N 3/098; G06N 20/00; G06N 20/20; H03M 7/3059; H03M 7/607; H04W 24/08**

(86) International application number:
**PCT/KR2022/017356**

(87) International publication number:
**WO 2023/090738 (25.05.2023 Gazette 2023/21)**

## (54) METHOD FOR PERFORMING FEDERATED LEARNING IN WIRELESS COMMUNICATION SYSTEM, AND APPARATUS THEREFOR

VERFAHREN ZUR DURCHFÜHRUNG VON FÖDERIERTEM LERNEN IN EINEM DRAHTLOSKOMMUNIKATIONSSYSTEM UND VORRICHTUNG DAFÜR

PROCÉDÉ PERMETTANT DE RÉALISER UN APPRENTISSAGE FÉDÉRÉ DANS UN SYSTÈME DE COMMUNICATION SANS FIL, ET APPAREIL ASSOCIÉ

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **22.11.2021 KR 20210161522**

(43) Date of publication of application:
**02.10.2024 Bulletin 2024/40**

(73) Proprietor: **LG Electronics Inc.**
**Yeongdeungpo-gu**
**Seoul 07336 (KR)**

(72) Inventors:
- **JEON, Kijun**
  **Seoul 06772 (KR)**
- **LEE, Sangrim**
  **Seoul 06772 (KR)**
- **JUNG, Ikjoo**
  **Seoul 06772 (KR)**
- **LEE, Hojae**
  **Seoul 06772 (KR)**
- **LEE, Taehyun**
  **Seoul 06772 (KR)**

(74) Representative: **Frenkel, Matthias Alexander et al**
**Wuesthoff & Wuesthoff**
**Patentanwälte und Rechtsanwalt PartG mbB**
**Schweigerstraße 2**
**81541 München (DE)**

(56) References cited:
**WO-A1-2021/127596**
**US-A1- 2021 097 430**
**US-A1- 2021 158 167**
**US-A1- 2021 241 173**

- **SRIKANTH CHANDAR ET AL: "Communication Optimization in Large Scale Federated Learning using Autoencoder Compressed Weight Updates", ARXIV.ORG, CORNELL UNIVERSITY LIBRARY, 201 OLIN LIBRARY CORNELL UNIVERSITY ITHACA, NY 14853, 12 August 2021 (2021-08-12), XP091031040**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 4 439 409 B1

- MOJTABA VAEZI ET AL: "Cellular, Wide-Area, and Non-Terrestrial IoT: A Survey on 5G Advances and the Road Towards 6G", ARXIV.ORG, CORNELL UNIVERSITY LIBRARY, 201 OLIN LIBRARY CORNELL UNIVERSITY ITHACA, NY 14853, 7 July 2021 (2021-07-07), XP091008992
- OPPO: "OPPO views on Rel-18 package", 3GPP DRAFT; RWS-210041, 3RD GENERATION PARTNERSHIP PROJECT (3GPP), MOBILE COMPETENCE CENTRE ; 650, ROUTE DES LUCIOLES ; F-06921 SOPHIA-ANTIPOLIS CEDEX ; FRANCE, vol. TSG RAN, no. Electronic Meeting; 20210622 - 20210702, 7 June 2021 (2021-06-07), Mobile Competence Centre ; 650, route des Lucioles ; F-06921 Sophia-Antipolis Cedex ; France , XP052025606
- SRIKANTH CHANDAR; PRAVIN CHANDRAN; RAGHAVENDRA BHAT; AVINASH CHAKRAVARTHI: "Communication Optimization in Large Scale Federated Learning using Autoencoder Compressed Weight Updates", ARXIV.ORG, CORNELL UNIVERSITY LIBRARY, 201 OLIN LIBRARY CORNELL UNIVERSITY ITHACA, NY 14853, 12 August 2021 (2021-08-12), 201 Olin Library Cornell University Ithaca, NY 14853, XP091031040
- CHOI YOOJIN, EL-KHAMY MOSTAFA, LEE JUNGWON: "Universal Deep Neural Network Compression", IEEE JOURNAL OF SELECTED TOPICS IN SIGNAL PROCESSING, IEEE, US, vol. 14, no. 4, 4 May 2020 (2020-05-04), US , pages 715 - 726, XP055782645, ISSN: 1932-4553, DOI: 10.1109/JSTSP.2020.2975903

## Description

[Technical Field]

The present disclosure relates to a method of performing federated learning, and more particularly to a method for a plurality of user equipments (UEs) to perform federated learning in a wireless communication system and a device therefor.

[Background Art]

Wireless communication systems have been widely deployed to provide various types of communication services such as voice or data. In general, the wireless communication system is a multiple access system capable of supporting communication with multiple users by sharing available system resources (bandwidth, transmission power, etc.). Examples of multiple access systems include a Code Division Multiple Access (CDMA) system, a Frequency Division Multiple Access (FDMA) system, a Time Division Multiple Access (TDMA) system, a Space Division Multiple Access (SDMA) system, an Orthogonal Frequency Division Multiple Access (OFDMA) system, a Single Carrier Frequency Division Multiple Access (SC-FDMA) system, and an Interleave Division Multiple Access (IDMA) system.

Relevant prior art disclosures in this technical field are: US 2021/097430 A1, US 2021/158167 A1, SRIKANTH CHANDAR ET AL: "Communication Optimization in Large Scale Federated Learning using Autoencoder Compressed Weight Updates" and MOJTABA VAEZI ET AL: "Cellular, Wide-Area, and Non-Terrestrial IoT: A Survey on 5G Advances and the Road Towards 6G".

[Disclosure]

[Technical Problem]

An object of the present disclosure is to provide a method of performing federated learning in a wireless communication system and a device therefor.

Another object of the present disclosure is to provide a method of selecting a data compression method applied when performing federated learning in a wireless communication system and a device therefor.

Another object of the present disclosure is to provide a method of applying an important-aware data compression method when performing federated learning in a wireless communication system and a device therefor.

Another object of the present disclosure is to provide a method for a server to post-process a local parameter transmitted based on an important-aware data compression method when performing federated learning in a wireless communication system and a device therefor.

The technical objects to be achieved by the present disclosure are not limited to those that have been described hereinabove merely by way of example, and other technical objects that are not mentioned can be clearly understood by those skilled in the art, to which the present disclosure pertains, from the following descriptions.

[Technical Solution]

The present disclosure provides a method of performing federated learning in a wireless communication system and a device therefor.

More specifically, in one aspect of the present disclosure, there is provided a method for a plurality of user equipments (UEs) to perform a federated learning in a wireless communication system, the method performed by one UE of the plurality of UEs comprising receiving, from a server, a channel state information reference signal (CSI-RS); transmitting, to the server, channel state information (CSI) calculated based on the CSI-RS; receiving, from the server, compression state information for determining a weight compression method of the one UE based on (i) information on a global parameter for the federated learning and (ii) channel state information of each of channels between the server and the plurality of UEs; determining the weight compression method based on (i) a difference between the global parameter and a global parameter received before a reception of the global parameter and (ii) the compression state information; and transmitting, to the server, a local parameter updated based on the determined weight compression method.

Determining the weight compression method may be performed based on a result of comparison between (i) an average value of the difference between the global parameter and the global parameter received before the reception of the global parameter and (ii) a preset threshold for determining the weight compression method.

Based on the average value of the difference between the global parameter and the global parameter received before the reception of the global parameter being greater than the preset threshold for determining the weight compression method, a first weight compression method may be used.

The first weight compression method may be a method of generating a compressed weight based on each of at least one weight generated as a result of learning of the one UE being uniformly quantized to have a data resolution.

Based on the average value of the difference between the global parameter and the global parameter received before the reception of the global parameter being less than the preset threshold for determining the weight compression method, a second weight compression method different from a first weight compression method may be used.

The second weight compression method may be a method of generating a compressed weight based on, for each of at least one weight generated as a result of learning of the one UE, (i) a bit string constituting information included in each weight being partitioned to generate at least one partitioned weight, and (ii) a partition with a highest importance among the at least one partitioned weight being selected.

For each of the at least one weight generated as the result of learning of the one UE, each of the at least one partitioned weight may be given a partition index.

The compressed weight of each of the at least one weight generated as the result of learning of the one UE may include (i) information on a weight sign, (ii) partition weight information based on the partition with the highest importance selected among the at least one partitioned weight, and (iii) information on a partition index of the partition with the highest importance included in the partition weight information.

The selected partition with the highest importance may be a partition including a bit, that is first located among at least one bit with a non-zero value included in a weight including the selected partition with the highest importance within the weight including the selected partition with the highest importance.

Based on values of all bits constituting a weight being zero, a partitioned weight last located among at least one partitioned weight included in the weight may be included in the compressed weight.

In another aspect of the present disclosure, there is provided a user equipment (UE) performing a federated learning with a plurality of UEs in a wireless communication system, the UE comprising a transmitter configured to transmit a radio signal; a receiver configured to receive the radio signal; at least one processor; and at least one computer memory operably connectable to the at least one processor, wherein the at least one computer memory is configured to store instructions performing operations based on being executed by the at least one processor, wherein the operations comprise receiving, from a server, a channel state information reference signal (CSI-RS); transmitting, to the server, channel state information (CSI) calculated based on the CSI-RS; receiving, from the server, compression state information for determining a weight compression method of the one UE based on (i) information on a global parameter for the federated learning and (ii) channel state information of each of channels between the server and the plurality of UEs; determining the weight compression method based on (i) a difference between the global parameter and a global parameter received before a reception of the global parameter and (ii) the compression state information; and transmitting, to the server, a local parameter updated based on the determined weight compression method.

In another aspect of the present disclosure, there is provided a method for a base station to perform a federated learning with a plurality of user equipments (UEs) in a wireless communication system, the method comprising transmitting, to each of the plurality of UEs, a channel state information reference signal (CSI-RS); receiving, from each of the plurality of UEs, channel state information (CSI) calculated based on the CSI-RS; transmitting, to each of the plurality of UEs, compression state information for determining a weight compression method of the plurality of UEs based on (i) information on a global parameter for the federated learning and (ii) channel state information of each of channels between a server and the plurality of UEs; and receiving, from each of the plurality of UEs, a local parameter updated based on the weight compression method determined based on (i) a difference between the global parameter and a global parameter transmitted before a transmission of the global parameter and (ii) the compression state information.

In another aspect of the present disclosure, there is provided a base station performing a federated learning with a plurality of user equipments (UEs) in a wireless communication system, the base station comprising a transmitter configured to transmit a radio signal; a receiver configured to receive the radio signal; at least one processor; and at least one computer memory operably connectable to the at least one processor, wherein the at least one computer memory is configured to store instructions performing operations based on being executed by the at least one processor, wherein the operations comprise transmitting, to each of the plurality of UEs, a channel state information reference signal (CSI-RS); receiving, from each of the plurality of UEs, channel state information (CSI) calculated based on the CSI-RS; transmitting, to each of the plurality of UEs, compression state information for determining a weight compression method of the plurality of UEs based on (i) information on a global parameter for the federated learning and (ii) channel state information of each of channels between a server and the plurality of UEs; and receiving, from each of the plurality of UEs, a local parameter updated based on the weight compression method determined based on (i) a difference between the global parameter and a global parameter transmitted before a transmission of the global parameter and (ii) the compression state information.

In another aspect of the present disclosure, there is provided a non-transitory computer readable medium (CRM) storing one or more instructions, wherein the one or more instructions executable by one or more processors are configured to allow a user equipment (UE) to receive, from a server, a channel state information reference signal (CSI-RS); transmit, to the server, channel state information (CSI) calculated based on the CSI-RS; receive, from the server, compression state information for determining a weight compression method of the UE based on (i) information on a global

parameter for a federated learning and (ii) channel state information of each of channels between the server and a plurality of UEs; determine the weight compression method based on (i) a difference between the global parameter and a global parameter received before a reception of the global parameter and (ii) the compression state information; and transmit, to the server, a local parameter updated based on the determined weight compression method.

In another aspect of the present disclosure, there is provided a device comprising one or more memories and one or more processors operably connected to the one or more memories, wherein the one or more processors are configured to allow the device to receive, from a server, a channel state information reference signal (CSI-RS); transmit, to the server, channel state information (CSI) calculated based on the CSI-RS; receive, from the server, compression state information for determining a weight compression method of a user equipment (UE) based on (i) information on a global parameter for a federated learning and (ii) channel state information of each of channels between the server and a plurality of UEs; determine the weight compression method based on (i) a difference between the global parameter and a global parameter received before a reception of the global parameter and (ii) the compression state information; and transmit, to the server, a local parameter updated based on the determined weight compression method.

[Advantageous Effects]

The present disclosure can perform federated learning in a wireless communication system.

The present disclosure can select a data compression method applied when performing federated learning in a wireless communication system and thus can apply an appropriate data compression method based on the degree of learning.

The present disclosure can apply can apply an appropriate data compression method based on the degree of learning when performing federated learning in a wireless communication system and thus can increase efficiency of federated learning.

The present disclosure can consider important information of information constituting a local parameter in data compression by applying an important-aware data compression method when performing federated learning in a wireless communication system.

Effects that could be achieved with the present disclosure are not limited to those that have been described hereinabove merely by way of example, and other effects and advantages of the present disclosure will be more clearly understood from the following description by a person skilled in the art to which the present disclosure pertains.

[Description of Drawings]

The accompanying drawings, which are included to provide a further understanding of the present disclosure and constitute a part of the detailed description, illustrate embodiments of the present disclosure and serve to explain technical features of the present disclosure together with the description.

FIG. 1 illustrates an example of physical channels and general signal transmission used for the 3GPP system.
FIG. 2 illustrates an example of a supportable communication structure in the 6G system.
FIG. 3 schematically illustrates an example of a structure of a perceptron.
FIG. 4 schematically illustrates an example of a structure of a multilayer perceptron.
FIG. 5 schematically illustrates an example of a deep neural network.
FIG. 6 schematically illustrates an example of a convolutional neural network.
FIG. 7 schematically illustrates an example of a filter operation in a convolutional neural network.
FIG. 8 schematically illustrates an example of a neural network structure in which a circular loop exists.
FIG. 9 schematically illustrates an example of an operation structure of a recurrent neural network.
FIG. 10 illustrates an example of federated learning performed between a plurality of devices and a server.
FIG. 11 illustrates another example of federated learning performed between a plurality of devices and a server.
FIG. 12 illustrates an example of a method of expressing a weight including a sign.
FIG. 13 illustrates an example of an overall process of performing a federated learning method to which a data compression method described in the present disclosure is applicable.
FIG. 14 illustrates an example of a process of performing a weight compression method.
FIG. 15 illustrates a root mean square error for each compression type based on gradient to a weight ratio.
FIG. 16 is a flow chart illustrating an example of a method for a UE to perform federated learning in a wireless communication system described in the present disclosure.
FIG. 17 is a flow chart illustrating an example of a method for a base station (server) to perform federated learning in a wireless communication system described in the present disclosure.
FIG. 18 illustrates a communication system 1 applied to the present disclosure.
FIG. 19 illustrates a wireless device applicable to the present disclosure.

FIG. 20 illustrates a signal processing circuit for a transmission signal.
FIG. 21 illustrates another example of a wireless device applied to the present disclosure.
FIG. 22 illustrates a hand-held device applied to the present disclosure.
FIG. 23 illustrates a vehicle or an autonomous vehicle applied to the present disclosure.
FIG. 24 illustrates a vehicle applied to the present disclosure.
FIG. 25 illustrates an XR device applied to the present disclosure.
FIG. 26 illustrates a robot applied to the present disclosure.

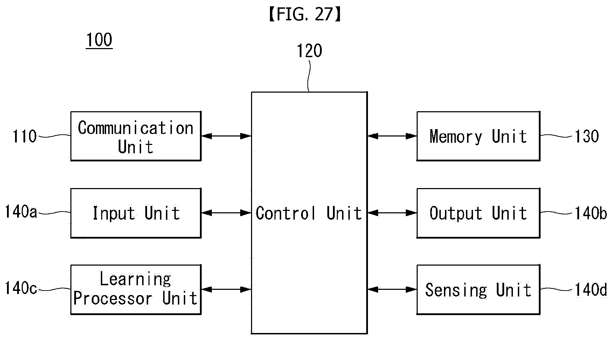

FIG. 27 illustrates an AI device applied to the present disclosure.

[Mode for Invention]

The following technology may be used in various radio access system including CDMA, FDMA, TDMA, OFDMA, SC-FDMA, and the like. The CDMA may be implemented as radio technology such as Universal Terrestrial Radio Access (UTRA) or CDMA2000. The TDMA may be implemented as radio technology such as a global system for mobile communications (GSM)/general packet radio service (GPRS)/enhanced data rates for GSM evolution (EDGE). The OFDMA may be implemented as radio technology such as Institute of Electrical and Electronics Engineers (IEEE) 802.11 (Wi-Fi), IEEE 802.16 (WiMAX), IEEE 802.20, Evolved UTRA (E-UTRA), or the like. The UTRA is a part of Universal Mobile Telecommunications System (UMTS). 3rd Generation Partnership Project (3GPP) Long Term Evolution (LTE) is a part of Evolved UMTS (E-UMTS) using the E-UTRA and LTE-Advanced (A)/LTE-A pro is an evolved version of the 3GPP LTE. 3GPP NR (New Radio or New Radio Access Technology) is an evolved version of the 3GPP LTE/LTE-A/LTE-A pro. 3GPP 6G may be an evolved version of 3GPP NR.

For clarity in the description, the following description will mostly focus on 3GPP communication system (e.g. LTE-A or 5G NR). However, technical features according to an embodiment of the present disclosure will not be limited only to this. LTE means technology after 3GPP TS 36.xxx Release 8. In detail, LTE technology after 3GPP TS 36.xxx Release 10 is referred to as the LTE-A and LTE technology after 3GPP TS 36.xxx Release 13 is referred to as the LTE-A pro. The 3GPP NR means technology after TS 38.xxx Release 15. The LTE/NR may be referred to as a 3GPP system. "xxx" means a detailed standard document number. The LTE/NR/6G may be collectively referred to as the 3GPP system. For terms and techniques not specifically described among terms and techniques used in the present disclosure, reference may be made to a wireless communication standard document published before the present disclosure is filed. For example, the following document may be referred to.

## 3GPP LTE

- 36.211: Physical channels and modulation
- 36.212: Multiplexing and channel coding
- 36.213: Physical layer procedures
- 36.300: Overall description
- 36.331: Radio Resource Control (RRC)

## 3GPP NR

- 38.211: Physical channels and modulation
- 38.212: Multiplexing and channel coding
- 38.213: Physical layer procedures for control
- 38.214: Physical layer procedures for data
- 38.300: NR and NG-RAN Overall Description
- 38.331: Radio Resource Control (RRC) protocol specification

## Physical Channel and Frame Structure

### Physical Channel and General Signal Transmission

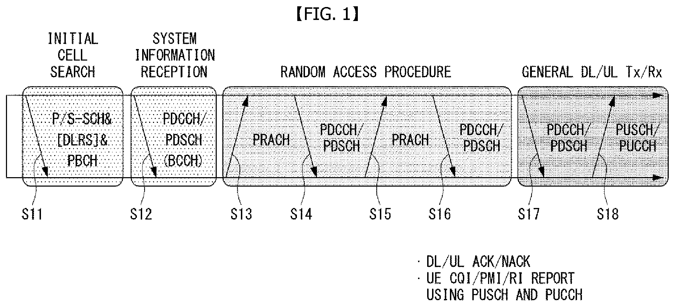

FIG. 1 illustrates an example of physical channels and general signal transmission used for the 3GPP system. In a wireless communication system, the UE receives information from the eNB through Downlink (DL) and the UE transmits

information from the eNB through Uplink (UL). The information which the eNB and the UE transmit and receive includes data and various control information and there are various physical channels according to a type/use of the information which the eNB and the UE transmit and receive.

When the UE is powered on or newly enters a cell, the UE performs an initial cell search operation such as synchronizing with the eNB (S11). To this end, the UE may receive a Primary Synchronization Signal (PSS) and a (Secondary Synchronization Signal (SSS) from the eNB and synchronize with the eNB and acquire information such as a cell ID or the like. Thereafter, the UE may receive a Physical Broadcast Channel (PBCH) from the eNB and acquire in-cell broadcast information. Meanwhile, the UE receives a Downlink Reference Signal (DL RS) in an initial cell search step to check a downlink channel status.

A UE that completes the initial cell search receives a Physical Downlink Control Channel (PDCCH) and a Physical Downlink Control Channel (PDSCH) according to information loaded on the PDCCH to acquire more specific system information (S12).

When there is no radio resource first accessing the eNB or for signal transmission, the UE may perform a Random Access Procedure (RACH) to the eNB (S13 to S16). To this end, the UE may transmit a specific sequence to a preamble through a Physical Random Access Channel (PRACH) (S13 and S15) and receive a response message (Random Access Response (RAR) message) for the preamble through the PDCCH and a corresponding PDSCH. In the case of a contention based RACH, a Contention Resolution Procedure may be additionally performed (S16).

The UE that performs the above procedure may then perform PDCCH/PDSCH reception (S17) and Physical Uplink Shared Channel (PUSCH)/Physical Uplink Control Channel (PUCCH) transmission (S18) as a general uplink/-downlink signal transmission procedure. In particular, the UE may receive Downlink Control Information (DCI) through the PDCCH. Here, the DCI may include control information such as resource allocation information for the UE and formats may be differently applied according to a use purpose.

The control information which the UE transmits to the eNB through the uplink or the UE receives from the eNB may include a downlink/uplink ACK/NACK signal, a Channel Quality Indicator (CQI), a Precoding Matrix Index (PMI), a Rank Indicator (RI), and the like. The UE may transmit the control information such as the CQI/PMI/RI, etc., via the PUSCH and/or PUCCH.

## Structure of Uplink and Downlink Channels

### Downlink Channel Structure

A base station transmits a related signal to a UE via a downlink channel to be described later, and the UE receives the related signal from the base station via the downlink channel to be described later.

(1) Physical Downlink Shared Channel (PDSCH)

A PDSCH carries downlink data (e.g., DL-shared channel transport block, DL-SCH TB) and is applied with a modulation method such as quadrature phase shift keying (QPSK), 16 quadrature amplitude modulation (QAM), 64 QAM, and 256 QAM. A codeword is generated by encoding TB. The PDSCH may carry multiple codewords. Scrambling and modulation mapping are performed for each codeword, and modulation symbols generated from each codeword are mapped to one or more layers (layer mapping). Each layer is mapped to a resource together with a demodulation reference signal (DMRS) to generate an OFDM symbol signal, and is transmitted through a corresponding antenna port.

(2) Physical Downlink Control Channel (PDCCH)

A PDCCH carries downlink control information (DCI) and is applied with a QPSK modulation method, etc. One PDCCH consists of 1, 2, 4, 8, or 16 control channel elements (CCEs) based on an aggregation level (AL). One CCE consists of 6 resource element groups (REGs). One REG is defined by one OFDM symbol and one (P)RB.

The UE performs decoding (aka, blind decoding) on a set of PDCCH candidates to acquire DCI transmitted via the PDCCH. The set of PDCCH candidates decoded by the UE is defined as a PDCCH search space set. The search space set may be a common search space or a UE-specific search space. The UE may acquire DCI by monitoring PDCCH candidates in one or more search space sets configured by MIB or higher layer signaling.

### Uplink Channel Structure

A UE transmits a related signal to a base station via an uplink channel to be described later, and the base station receives the related signal from the UE via the uplink channel to be described later.

(1) Physical Uplink Shared Channel (PUSCH)

A PUSCH carries uplink data (e.g., UL-shared channel transport block, UL-SCH TB) and/or uplink control information (UCI) and is transmitted based on a CP-OFDM (Cyclic Prefix-Orthogonal Frequency Division Multiplexing) waveform, DFT-s-OFDM (Discrete Fourier Transform-spread-Orthogonal Frequency Division Multiplexing) waveform, or the like. When the PUSCH is transmitted based on the DFT-s-OFDM waveform, the UE transmits the PUSCH by applying a transform precoding. For example, if the transform precoding is not possible (e.g., transform precoding is disabled), the UE may transmit the PUSCH based on the CP-OFDM waveform, and if the transform precoding is possible (e.g., transform precoding is enabled), the UE may transmit the PUSCH based on the CP-OFDM waveform or the DFT-s-OFDM waveform. The PUSCH transmission may be dynamically scheduled by an UL grant within DCI, or may be semi-statically scheduled based on high layer (e.g., RRC) signaling (and/or layer 1 (L1) signaling (e.g., PDCCH)) (configured grant). The PUSCH transmission may be performed based on a codebook or a non-codebook.

(2) Physical Uplink Control Channel (PUCCH)

A PUCCH carries uplink control information, HARQ-ACK, and/or scheduling request (SR), and may be divided into multiple PUCCHs based on a PUCCH transmission length.

**6G system general**

A 6G (wireless communication) system has purposes such as (i) a very high data rate per device, (ii) a very large number of connected devices, (iii) global connectivity, (iv) a very low latency, (v) a reduction in energy consumption of battery-free IoT devices, (vi) ultra-reliable connectivity, and (vii) connected intelligence with machine learning capability. The vision of the 6G system may include four aspects such as intelligent connectivity, deep connectivity, holographic connectivity, and ubiquitous connectivity, and the 6G system may satisfy the requirements shown in Table 1 below. That is, Table 1 shows an example of the requirements of the 6G system.

[Table 1]

| | |
|---|---|
| **Per device peak data rate** | 1 Tbps |
| **E2E latency** | 1 ms |
| **Maximum spectral efficiency** | 100bps/Hz |
| **Mobility support** | Up to 1000km/hr |
| **Satellite integration** | Fully |
| **AI** | Fully |
| **Autonomous vehicle** | Fully |
| **XR** | Fully |
| **Haptic Communication** | Fully |

The 6G system may have key factors such as enhanced mobile broadband (eMBB), ultra-reliable low latency communications (URLLC), massive machine type communications (mMTC), AI integrated communication, tactile Internet, high throughput, high network capacity, high energy efficiency, low backhaul and access network congestion, and enhanced data security.

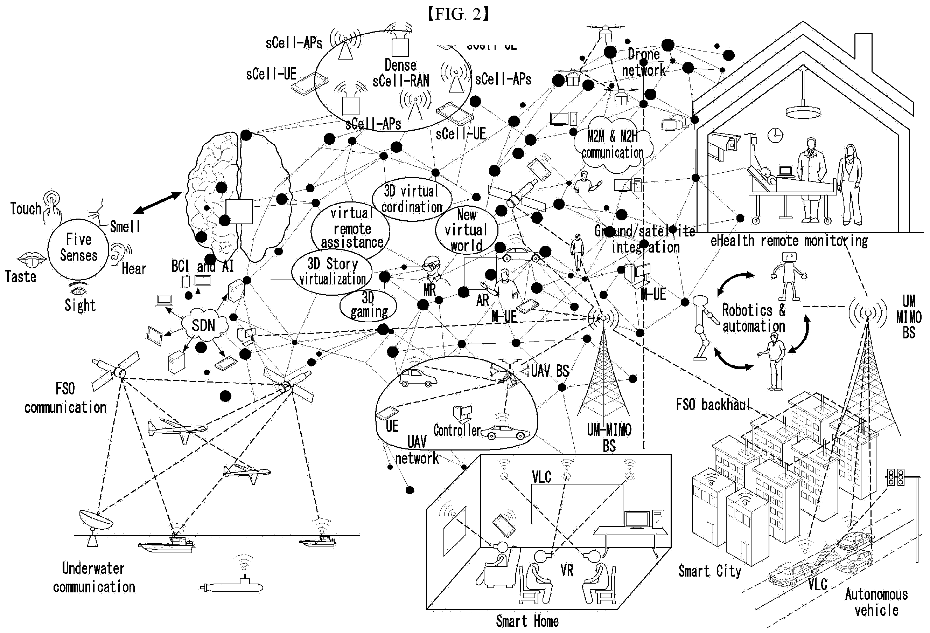

FIG. 2 illustrates an example of a communication structure providable in a 6G system.

The 6G system is expected to have 50 times greater simultaneous wireless communication connectivity than a 5G wireless communication system. URLLC, which is the key feature of 5G, will become more important technology by providing an end-to-end latency less than 1 ms in 6G communication. The 6G system may have much better volumetric spectrum efficiency unlike frequently used domain spectrum efficiency. The 6G system can provide advanced battery technology for energy harvesting and very long battery life, and thus mobile devices may not need to be separately charged in the 6G system. In 6G, new network characteristics may be as follows.

- Satellites integrated network: To provide a global mobile group, 6G will be integrated with satellite. Integration of terrestrial, satellite and public networks into one wireless communication system is critical for 6G.
- Connected intelligence: Unlike the wireless communication systems of previous generations, 6G is innovative and may update wireless evolution from "connected things" to "connected intelligence". AI may be applied in each step (or

each signal processing procedure to be described later) of a communication procedure.

Seamless integration wireless information and energy transfer

- Ubiquitous super 3D connectivity: Access to networks and core network functions of drone and very low earth orbit satellite will establish super 3D connectivity in 6G ubiquitous.

In the new network characteristics of 6G described above, several general requirements may be as follows.

- Small cell networks: The idea of a small cell network has been introduced to improve received signal quality as a result of throughput, energy efficiency, and spectrum efficiency improvement in a cellular system. As a result, the small cell network is an essential feature for 5G and beyond 5G (5GB) communication systems. Accordingly, the 6G communication system also employs the characteristics of the small cell network.
- Ultra-dense heterogeneous network: Ultra-dense heterogeneous networks will be another important characteristic of the 6G communication system. A multi-tier network consisting of heterogeneous networks improves overall QoS and reduces costs.
- High-capacity backhaul: Backhaul connectivity is characterized by a high-capacity backhaul network in order to support high-capacity traffic. A high-speed optical fiber and free space optical (FSO) system may be a possible solution for this problem.
- Radar technology integrated with mobile technology: High-precision localization (or location-based service) through communication is one of the functions of the 6G wireless communication system. Accordingly, the radar system will be integrated with the 6G network.
- Softwarization and virtualization: Softwarization and virtualization are two important functions which are the bases of a design process in a 5GB network in order to ensure flexibility, reconfigurability and programmability. Further, billions of devices can be shared on a shared physical infrastructure.

## Core implementation technology of 6G System

### Artificial Intelligence (AI)

Technology which is most important in the 6G system and will be newly introduced is AI. AI was not involved in the 4G system. The 5G system will support partial or very limited AI. However, the 6G system will support AI for full automation. Advance in machine learning will create a more intelligent network for real-time communication in 6G. When AI is introduced to communication, real-time data transmission can be simplified and improved. AI may determine a method of performing complicated target tasks using countless analysis. That is, AI can increase efficiency and reduce processing delay.

Recently, attempts have been made to integrate AI with a wireless communication system in the application layer or the network layer, and in particular, deep learning has been focused on the wireless resource management and allocation field. However, such studies have been gradually developed to the MAC layer and the physical layer, and in particular, attempts to combine deep learning in the physical layer with wireless transmission are emerging.

AI-based physical layer transmission means applying a signal processing and communication mechanism based on an AI driver rather than a traditional communication framework in a fundamental signal processing and communication mechanism. For example, channel coding and decoding based on deep learning, signal estimation and detection based on deep learning, multiple input multiple output (MIMO) mechanisms based on deep learning, resource scheduling and allocation based on AI, etc. may be included.

Machine learning may be used for channel estimation and channel tracking and may be used for power allocation, interference cancellation, etc. in the physical layer of DL. The machine learning may also be used for antenna selection, power control, symbol detection, etc. in the MIMO system.

Machine learning refers to a series of operations to train a machine in order to create a machine capable of doing tasks that people cannot do or are difficult for people to do. Machine learning requires data and learning models. In the machine learning, a data learning method may be roughly divided into three methods, that is, supervised learning, unsupervised learning and reinforcement learning.

Neural network learning is to minimize an output error. The neural network learning refers to a process of repeatedly inputting training data to a neural network, calculating an error of an output and a target of the neural network for the training data, backpropagating the error of the neural network from an output layer to an input layer of the neural network for the purpose of reducing the error, and updating a weight of each node of the neural network.

The supervised learning may use training data labeled with a correct answer, and the unsupervised learning may use training data which is not labeled with a correct answer. That is, for example, in supervised learning for data

classification, training data may be data in which each training data is labeled with a category. The labeled training data may be input to the neural network, and the error may be calculated by comparing the output (category) of the neural network with the label of the training data. The calculated error is backpropagated in the neural network in the reverse direction (i.e., from the output layer to the input layer), and a connection weight of respective nodes of each layer of the neural network may be updated based on the backpropagation. Change in the updated connection weight of each node may be determined depending on a learning rate. The calculation of the neural network for input data and the back-propagation of the error may construct a learning cycle (epoch). The learning rate may be differently applied based on the number of repetitions of the learning cycle of the neural network. For example, in the early stage of learning of the neural network, efficiency can be increased by allowing the neural network to rapidly ensure a certain level of performance using a high learning rate, and in the late of learning, accuracy can be increased using a low learning rate.

The learning method may vary depending on the feature of data. For example, in order for a reception end to accurately predict data transmitted from a transmission end on a communication system, it is preferable that learning is performed using the supervised learning rather than the unsupervised learning or the reinforcement learning.

The learning model corresponds to the human brain and may be regarded as the most basic linear model. However, a paradigm of machine learning using, as the learning model, a neural network structure with high complexity, such as artificial neural networks, is referred to as deep learning.

Neural network cores used as the learning method may roughly include a deep neural network (DNN) method, a convolutional deep neural network (CNN) method, and a recurrent Boltzmann machine (RNN) method.

The artificial neural network is an example of connecting several perceptrons.

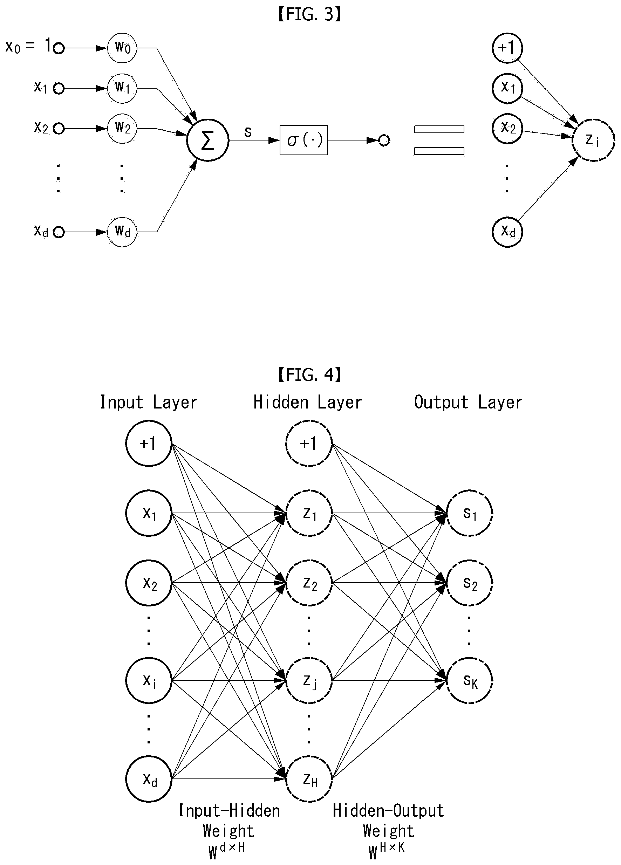

Referring to FIG. 3, when an input vector x=(x1, x2, ..., xd) is input, each component is multiplied by a weight (W1, W2, ..., Wd), and all the results are summed. After that, the entire process of applying an activation function $\sigma(\cdot)$ is called a perceptron. The huge artificial neural network structure may extend the simplified perceptron structure illustrated in FIG. 3 to apply the input vector to different multidimensional perceptrons. For convenience of explanation, an input value or an output value is referred to as a node.

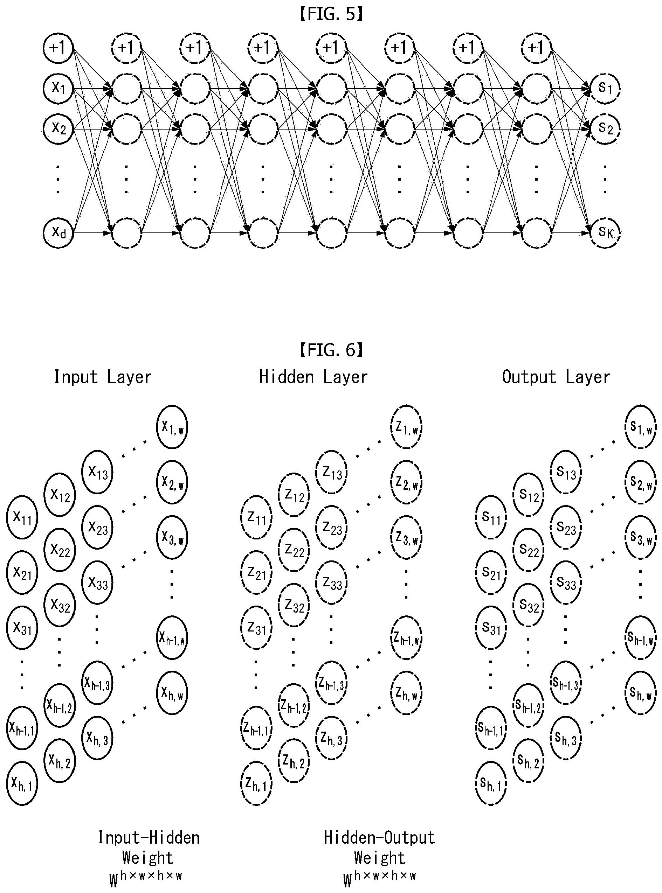

The perceptron structure illustrated in FIG. 6 may be described as consisting of a total of three layers based on the input value and the output value. FIG. 4 illustrates an artificial neural network in which the number of (d+1) dimensional perceptrons between a first layer and a second layer is H, and the number of (H+1) dimensional perceptrons between the second layer and a third layer is K, by way of example.

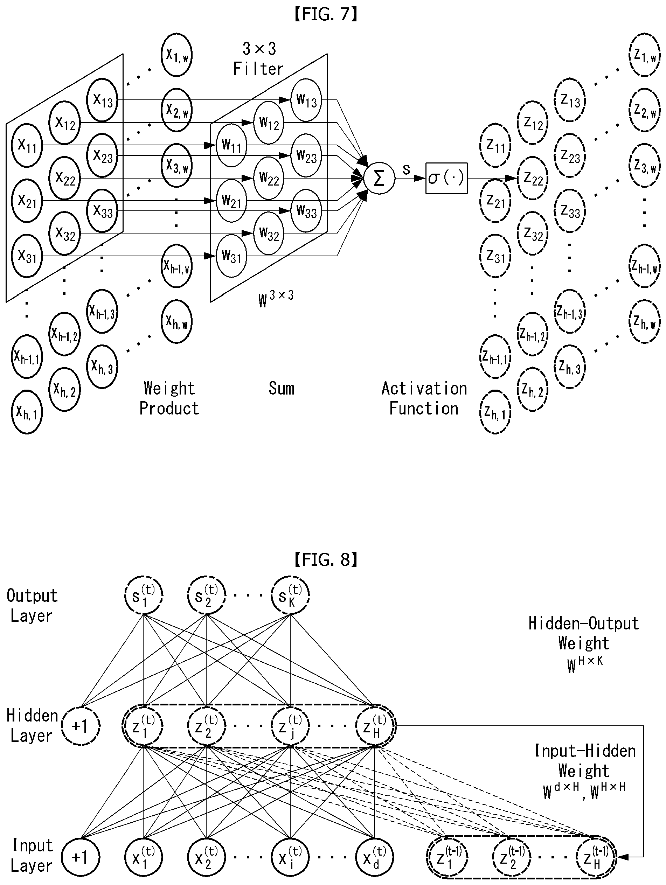

A layer where the input vector is located is called an input layer, a layer where a final output value is located is called an output layer, and all layers located between the input layer and the output layer are called a hidden layer. FIG. 7 illustrates three layers, by way of example. However, since the number of layers of the artificial neural network is counted excluding the input layer, it can be seen as a total of two layers. The artificial neural network is constructed by connecting the perceptrons of a basic block in two-dimension.

The above-described input layer, hidden layer, and output layer can be jointly applied in various artificial neural network structures, such as CNN and RNN to be described later, as well as the multilayer perceptron. The greater the number of hidden layers, the deeper the artificial neural network is, and a machine learning paradigm that uses the sufficiently deep artificial neural network as a learning model is called deep learning. In addition, the artificial neural network used for deep learning is called a deep neural network (DNN).

The deep neural network illustrated in FIG. 8 is a multilayer perceptron consisting of eight hidden layers + eight output layers. The multilayer perceptron structure is expressed as a fully connected neural network. In the fully connected neural network, a connection relationship does not exist between nodes located at the same layer, and a connection relationship exists only between nodes located at adjacent layers. The DNN has a fully connected neural network structure and is composed of a combination of multiple hidden layers and activation functions, so it can be usefully applied to understand correlation characteristics between input and output. The correlation characteristic may mean a joint probability of input and output.

Based on how the plurality of perceptrons are connected to each other, various artificial neural network structures different from the above-described DNN can be formed.

In the DNN, nodes located inside one layer are arranged in a one-dimensional longitudinal direction. However, in FIG. 6, it may be assumed that w nodes horizontally and h nodes vertically are arranged in two dimensions (convolutional neural network structure of FIG. 6). In this case, since in a connection process leading from one input node to the hidden layer, a weight is given for each connection, a total of $h \times w$ weights needs to be considered. Since there are $h \times w$ nodes in the input layer, a total of h2w2 weights are required between two adjacent layers.

FIG. 6 illustrates an example of a structure of a convolutional neural network.

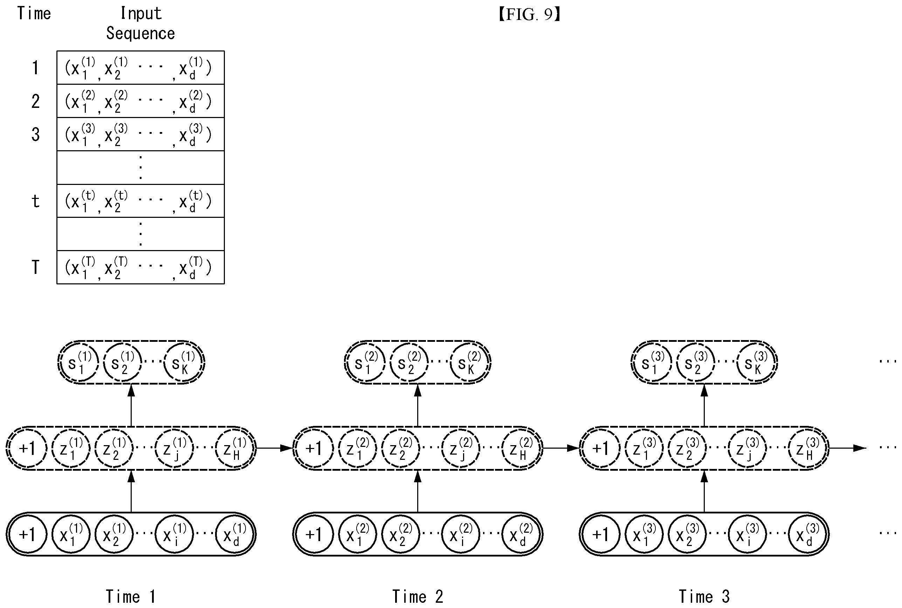

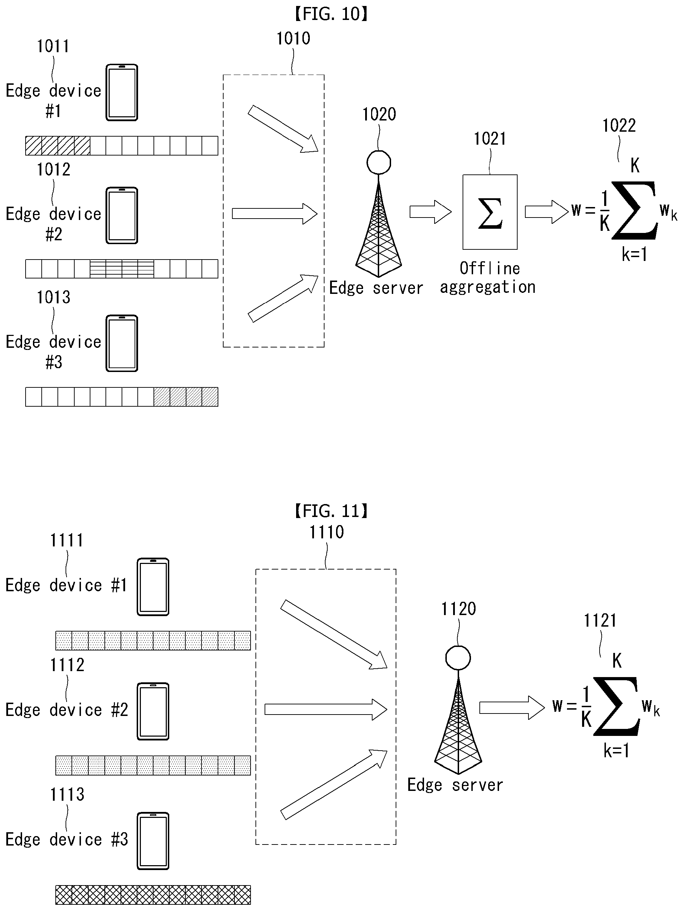

The convolutional neural network of FIG. 9 has a problem in that the number of weights increases exponentially depending on the number of connections. Therefore, instead of considering the connections of all the nodes between adjacent layers, it is assumed that a small-sized filter exists, and a weighted sum and an activation function calculation are performed on an overlap portion of the filters as illustrated in FIG. 10.

One filter has a weight corresponding to the number as much as its size, and learning of the weight may be

performed so that a certain feature on an image can be extracted and output as a factor. In FIG. 10, a filter having a size of 3×3 is applied to the upper leftmost 3×3 area of the input layer, and an output value obtained by performing a weighted sum and an activation function calculation for a corresponding node is stored in z22.

The filter performs the weighted sum and the activation function calculation while moving horizontally and vertically by a predetermined interval when scanning the input layer, and places the output value at a location of a current filter. This calculation method is similar to the convolution operation on images in the field of computer vision. Thus, a deep neural network with this structure is referred to as a convolutional neural network (CNN), and a hidden layer generated as a result of the convolution operation is referred to as a convolutional layer. In addition, a neural network in which a plurality of convolutional layers exists is referred to as a deep convolutional neural network (DCNN).

FIG. 7 illustrates an example of a filter operation of a convolutional neural network.

At the node where a current filter is located at the convolutional layer, the number of weights may be reduced by calculating a weighted sum including only nodes located in an area covered by the filter. Hence, one filter can be used to focus on features for a local area. Accordingly, the CNN can be effectively applied to image data processing in which a physical distance on the 2D area is an important criterion. In the CNN, a plurality of filters may be applied immediately before the convolution layer, and a plurality of output results may be generated through a convolution operation of each filter.

There may be data whose sequence characteristics are important depending on data attributes. A structure, in which a method of inputting one element on the data sequence at each time step considering a length variability and a relationship of the sequence data and inputting an output vector (hidden vector) of a hidden layer output at a specific time step together with a next element on the data sequence is applied to the artificial neural network, is referred to as a recurrent neural network structure.

Referring to FIG. 8, a recurrent neural network (RNN) is a structure in which in a process of inputting elements (x1(t), x2(t),..., xd(t)) of any line of sight 't' on a data sequence to a fully connected neural network, hidden vectors (z1(t-1), z2(t-1), ..., zH(t-1)) are input together at an immediately previous time step (t-1) to apply a weighted sum and an activation function. A reason for transferring the hidden vectors at a next time step is that information within the input vector in previous time steps is considered to be accumulated on the hidden vectors of a current time step.

FIG. 8 illustrates an example of a neural network structure in which a circular loop exists.

Referring to FIG. 8, the recurrent neural network operates in a predetermined order of time with respect to an input data sequence.

Hidden vectors (z1(1), z2(1), ..., zH(1)) when input vectors (x1(t), x2(t), ..., xd(t)) at a time step 1 are input to the recurrent neural network, are input together with input vectors (x1(2), x2(2), ..., xd(2)) at a time step 2 to determine vectors (z1(2), z2(2), ..., zH(2)) of a hidden layer through a weighted sum and an activation function. This process is repeatedly performed at time steps 2, 3, ..., T.

FIG. 9 illustrates an example of an operation structure of a recurrent neural network.

When a plurality of hidden layers are disposed in the recurrent neural network, this is referred to as a deep recurrent neural network (DRNN). The recurrent neural network is designed to be usefully applied to sequence data (e.g., natural language processing).

A neural network core used as a learning method includes various deep learning methods such as a restricted Boltzmann machine (RBM), a deep belief network (DBN), and a deep Q-network, in addition to the DNN, the CNN, and the RNN, and may be applied to fields such as computer vision, speech recognition, natural language processing, and voice/signal processing.

## Federated Learning

In federated learning which is a scheme of distributed machine learning, each of a plurality of devices that are the subjects of learning shares local model parameters with a server, and the server collects the local model parameters of each device and updates a global parameter. The local model parameters may include parameters such as weight and gradient of a local model, and it is obvious that the local model parameters can be expressed in various ways within the range in which they can be interpreted identically/similarly to local parameters, etc. If federated learning is applied to 5G communication or 6G communication, the device may be a user equipment (UE), and the server may be a base station (BS). Hereinafter, the UE/device/transmitter and the server/base station/receiver may be used interchangeably for convenience of explanation.

In the above process, each device does not share raw data with the server, thereby reducing communication overhead during a data transmission process and protecting personal information of the device (user).

FIG. 10 illustrates an example of federated learning performed between a plurality of devices and a server.

More specifically, FIG. 10 illustrates a working process of orthogonal division access based federated learning.

Devices 1011, 1012 and 1013 transmit their local parameters to a server 1020 on resources allocated to each of the devices 1011, 1012 and 1013 (1010). In this instance, before the devices 1011, 1012 and 1013 transmit the local

parameters, the devices 1011, 1012 and 1013 may receive configuration information on learning parameters for federated learning from the server 1020. The configuration information on the learning parameters for federated learning may include parameters such as weight and gradient of local models, and the learning parameters included in the local parameters transmitted by the devices 1011, 1012 and 1013 may be determined based on the configuration information. After the reception of the configuration information, the devices 1011, 1012 and 1013 may receive control information for resource allocation for transmission of the local parameters. Each of the devices 1011, 1012 and 1013 may transmit the local parameters on resources allocated based on the control information.

Afterwards, the server 1020 performs offline aggregation (1021 and 1022) on the local parameters received from each of the devices 1011, 1012 and 1013.

In general, the server 1020 derives a global parameter through averaging of all the local parameters received from the devices 1011, 1012 and 1013 participating in federated learning, and transmits the derived global parameter to each of the devices 1011, 1012 and 1013.

However, in the working process of the orthogonal division access based federated learning, overhead generated in terms of the use of radio resources is very large (i.e., radio resources are linearly required as many as the number of devices participating in learning). Further, in the working process of the orthogonal division access based federated learning on limited resources, as the number of devices participating in federated learning increases, there may be a problem that the time required to update the global parameter is delayed (increased).

FIG. 11 illustrates another example of federated learning performed between a plurality of devices and a server.

More specifically, FIG. 11 illustrates a working process of Over-the-Air (OTA) computation based federated learning. The OTA computation may be briefly referred to as Aircomp.

The Aircomp based federated learning is a method in which all devices participating in federated learning each transmit their local parameters on the same resources. Hence, the Aircomp based federated learning can solve the problem, described above with reference to FIG. 10, that the time required to update the global parameter is delayed as the number of devices participating in learning increases.

In FIG. 11, devices 1111, 1112 and 1113 transmit their local parameters to a server 1120 on equally allocated resources (1110). In this instance, before the devices 1111, 1112 and 1113 transmit the local parameters, the operations (configuration information reception and control information reception) performed before transmission of the local parameters described in FIG. 10 may be performed in the same manner in FIG. 11.

The local parameters transmitted by the devices 1111, 1112 and 1113 are transmitted based on an analog method or a digital method. The analog method means that pulse amplitude modulation (PAM) is simply applied to a gradient value, and the digital method means that quadrature amplitude modulation (QAM) or phase shift keying (PSK), which is a typical digital modulation method, is applied to a gradient value. The server 1120 may obtain a sum of the local parameters transmitted based on the analog or digital method received by superposition on air (1121). Afterwards, the server 1120 derives a global parameter through averaging of all the local parameters and transmits the derived global parameter to each of the devices 1111, 1112 and 1113.

In the AirComp based federated learning, because devices participating in the federated learning each transmit local parameters on the same resources, the number of devices participating in learning does not significantly affect latency. That is, even if the number of devices participating in the federated learning increases, the time it takes to update the global parameter does not change significantly compared to when a small number of devices participate in the federated learning. Therefore, the AirComp based federated learning can be efficient in terms of radio resource management. During the AirComp based federated learning, data compression may be performed, and examples of the data compression may include a model pruning method and a low-level compression (weight quantization) method. The model pruning method is a method in which some weights of all weight sets are selected and transmitted, and the low-level compression method is a method of lowering a resolution of each weight and uniformly quantizing and transmitting them.

The low-level compression method is simple and enables efficient compression with relatively small loss in an early stage of learning, but has the disadvantage of not contributing to improving model accuracy after a mid-stage of learning. Therefore, the low-level compression method has limitations as a compression method of model learning aimed at ensuring high reliability. The early stage of learning may mean a situation in which a variance of local gradient is large, that is, a situation in which many updates occur. In the model pruning method, as transmitted weight index information is included and transmitted, the communication overhead efficiency obtained through the pruning is reduced. In addition, in the AirComp method that assumes that each device participating in federated learning transmits model sequences of the same length, there are restrictions on weight pruning. Accordingly, the present disclosure proposes an efficient data compression method in an AirComp environment premised on the use of restriction based scalable Q-ary code. More specifically, the method proposed by the present disclosure relates to a method of hybridly performing a low-level compression method and an important-aware compression method based on the progress of model learning.

Before describing the method proposed by the present disclosure, a method of expressing each weight as a binary string is described. When each weight information is expressed as a binary sequence of length S, there may be a

method of expressing it in an unsigned format and a method of expressing it in a signed format. Table 2 below shows, when weight information is expressed as a binary sequence of length S, a method of expressing it in an unsigned format and a method of expressing it in a signed format, by way of example.

[Table 2]

| | Unsigned | Signed |
|---|---|---|
| Weight Range | $w_u^{\mathrm{us}}[n] \in [0, \sum_{l=0}^{S-1} 2^l]$ | $w_u^{\mathrm{s}}[n] \in [-2^{S-1}+1, 2^{S-1}-1]$ |
| Weight repre-sentatio n | $\tau_{\mathrm{us}}^{\mathrm{s2b}}(w_u^{\mathrm{us}}[n], q) = \mathbf{w}_{u,n}^{\mathrm{us,b}}$ where $w_{u,n}^{\mathrm{us,b}}[m] = \left\lfloor \frac{w_u^{\mathrm{us}}[n] - \sum_{l=1}^{m-1} 2^{q-l} w_{u,n}^{\mathrm{us,b}}[l]}{2^{q-m}} \right\rfloor$ | $\tau_{\mathrm{s}}^{\mathrm{s2b}}(w_u^{\mathrm{s}}[n], q) = \mathbf{w}_{u,n}^{\mathrm{s,b}} = \mathbf{w}_{u,n}^{\mathrm{s,b}}[q(m-1)+1:qm]$ where $w_{u,n}^{\mathrm{s,b}}[m] = \begin{cases} sgn^{+}(w_u^{\mathrm{s}}[n]), & \text{if } m = 1, \\ \frac{\lvert w_u^{\mathrm{s}}[n] \rvert_1 - \sum_{l=2}^{m-1} 2^{q-l} w_{u,n}^{\mathrm{s,b}}[l]}{2^{q-m}}, & \text{else.} \end{cases}$ |
| Example | 0: 000, 1: 001, 2: 010, 3:011, 4: 100, 5: 101, 6: 110, 7: 111 | -3: 011, -2: 010, -1: 001, 0: 100, 1: 101, 2: 110, 3: 111 |

While the unsigned expression method has the advantage of simplifying weight expression and being able to express $2^S$ values, it is impossible to distinguish bits that significantly affect the values. That is, it is not easy to measure importance. The signed expression method has the disadvantage that the weight expression is relatively complex and that only $2^S$ - 1 values can be expressed because one 'it' is used in the sign expression. On the other hand, the signed expression method has the advantage of making it easy to measure importance because the degree to which each bit significantly affects the value is different.

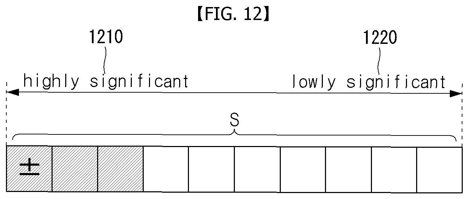

FIG. 12 illustrates an example of a method of expressing a weight including a sign. Referring to FIG. 12, if the most significant bit (MSB) represents sign information, and remaining bits constituting the weight are mapped to weight values in a descending manner from left to right, information located on the left may be considered more important information than information located further on the right.

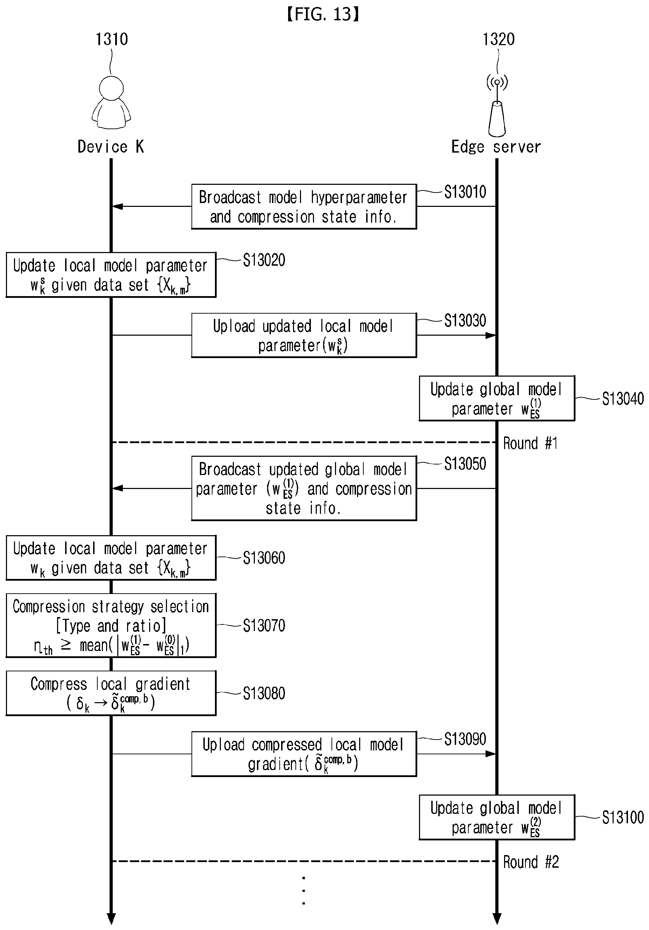

FIG. 13 illustrates an example of an overall process of performing a federated learning method to which a data compression method described in the present disclosure is applicable.

S13010: Each device 1310 participating in federated learning receives, from a server 1320, hyper-parameter information and data compression state information on a learning model.

S13020, S13030: Each device 1310 participating in federated learning performs learning based on the received hyper-parameter information and data compression state information, and acquires an initial local model (local parameter) through this. In this instance, the device 1310 performs compression on the acquired local model based on a compression strategy matching to compression state information and transmits the compressed information to the server 1320. Information on the local model may mean information on weights.

S13040: The server 1320 aggregates the information on the local model received from each device 1310 to acquire global model (global parameter) information. Information on the global model may mean information on the weights.

S13050: In a second round (Round #1) performed after the steps S13010 to S13040, the server 1320 transmits the compression state information to each device 1310 based on the updated global model, a current channel state, and a resource operation status. The compression state information may be considered information similar to a modulation and coding scheme (MCS) in terms of compression. More specifically, in the low-level compression method, the compression state information may be information about how to uniformly quantize the local model into how many bits. Further, in the important-aware compression method, when the local model is partitioned, each index may include the total number of partitions, information on the number of bits per partition, and information matching to tuple. In this instance, since a channel state, etc. may be considered in constituting the compression state information, channel state information received from each device 1310 may be used to constitute the compression state information in the server 1320. Therefore, in this step, the respective devices 1310 may receive a channel state information reference signal (CSI-RS) from the server 1320 and transmit channel state information (CSI) calculated based on the CSI-RS to the server 1320.

S13060: Each device 1310 selects a compression mode to be used for data compression based on a difference between the global model received in the second round and a global model that has been received in a previous round.

S13070, S13080: Each device 1310 performs compression on the local model/local gradient acquired after learning based on the compression strategy matching to the compression state information of the selected model received from the server 1320, and then transmits it to the server 1320.

S13090: Next, the server 1320 aggregates the local model/local parameter/local gradient received from each device 1310 to update the global model/global parameter.

## Weight compression mode selection

A method of selecting a weight compression mode described in the present disclosure is described below.

The method of selecting the weight compression mode described in the present disclosure considers the following two conditions.

All devices participating in federated learning first select the same compression mode in order to deliver a local model in AirComp format. Next, the devices participating in federated learning select the compression mode without side information from an edge server.

The method of selecting the weight compression mode described in the present disclosure performed based on the two conditions is as follows.

If a global model parameter that the device participating in federated learning in an i-th learning round (Round i) receives from the server is $\mathrm{W}_{\mathrm{ES}}^{(\mathrm{i}-1)}$, the device participating in federated learning selects the weight compression mode through a comparison between an average value of a difference between $\mathrm{W}_{\mathrm{ES}}^{(\mathrm{i}-1)}$ and a global model parameter received in a previous round (Round i-1) and a threshold. The threshold may be a preset value.

The method of selecting the weight compression mode described above can be expressed as in Equation 1 below.

【Equation 1】

$$\mathrm{mode}_{\mathrm{selection}} = \begin{cases} \text{low} - \text{level compression}, & \text{if mean}\left(\left|\mathbf{W}_{\mathrm{ES}}^{(i-1)} - \mathbf{W}_{\mathrm{ES}}^{(i-2)}\right|\right) > \eta_{th} \\ \text{important} - \text{aware compression}, \text{else}, & \end{cases}$$

The fact that the average value of the difference between the global model parameters is greater than the threshold means that there is still a lot left for the learned model to converge. Therefore, the respective devices participating in federated learning select a low-level compression mode that is decided to be more efficient based on their current level of learning, and perform the weight compression on local gradient information/local model information/local parameter information acquired through the learning in a manner of matching to the compression state information. On the contrary, if the average value of the difference between the global model parameters is less than the threshold, this means that the learning is starting to converge to some extent. Therefore, the respective devices participating in federated learning select an important-aware compression mode that is decided to be more efficient based on their current level of learning, and perform the weight compression on local gradient information/local model information/local parameter information acquired through the learning in a manner of matching to the compression state information.

An important-aware compression methodology is described in detail below.

## Important-aware weight compression methodology

As described above, when performing AirComp based federated learning, sequence lengths of all devices participating in federated learning shall be equally adjusted and delivered. Therefore, an important-aware weight compression methodology described in the present disclosure is a method of selecting and transmitting importance information of weights generated/acquired by a UE participating in federated learning, instead of transmitting a whole weight not performing a weight selection on the generated/acquired weights.

Information that the UE participating in federated learning transmits to a server based on the important-aware weight compression methodology is as follows. First, sign information shall be included. Second, bit sequences mapped to values are partitioned, and bit sequence information is included in the form of including partition indicator information and bit sequence information corresponding to a partition. That is, when each weight generated by the UE is a binary sequence of length S, the weight may be compressed into a binary sequence of length S* as shown in Equation 2 below.

【Equation 2】

$$S \rightarrow S^{*}(= \underbrace{1}_{\text{sign}} + \underbrace{\lceil log_2 p \rceil}_{\substack{\text{partition}\\ \text{indicator}}} + \underbrace{\bar{S}/p}_{\substack{\text{important}\\ \text{scalar term}}})$$

More specifically, assuming an i-th round in federated learning, global model weight information received by the UE from the server can be expressed as $\mathrm{w}_{\mathrm{ES}}^{(\mathrm{i}-1)}$. In this instance, the global model weight information may be an n-th component $\mathrm{w}_{\mathrm{BS}}^{(\mathrm{i}-1)}[\mathrm{n}]$ of $\mathrm{w}_{\mathrm{ES}}^{(\mathrm{i}-1)}$. Local model weights learned and updated on a specific device Device-u participating in federated learning and the n-th component $\mathrm{w}_{\mathrm{BS}}^{(\mathrm{i}-1)}[\mathrm{n}]$ can be expressed as $\mathrm{w}_{\mathrm{u}}^{\mathrm{s}}$ and $\mathrm{w}_{\mathrm{u}}^{\mathrm{s}}[\mathrm{n}]$. In this instance, an n-th component $\delta_u[n]$ of local gradient weights transmitted by the specific device Device-u to the server can be expressed as in Equation 3 below.

【Equation 3】

$$\delta_u[n] = \theta\left(w_u^s[n] - w_{BS}^{(i-1)}[n], S\right) \text{ where } \theta(a, S) = \begin{cases} (2sgn^+(a) - 1)(2^{S-1} - 1), & \text{if } |a|_1 \geq 2^{S-1} - 1 \\ a, & \text{else,} \end{cases}$$

where $sgn^+(a) = 1$ if $a \geq 0$ and 0, otherwise.

A column vector in which $\delta_u[n]$ is expressed as a binary representation of length S may be $\delta_{\mathrm{u,n}}^{\mathrm{b}}$.

In this instance, the column vector may have a relationship shown in Equation 4 below.

【Equation 4】

$$\boldsymbol{\delta}_{u,n}^{\mathrm{b}} = \tau_{\mathrm{us}}^{\mathrm{s2b}}(\delta_u[n], S)$$

A local gradient matrix constructed by concatenating the respective column vectors is expressed as $\delta_{\mathrm{u}}^{\mathrm{b}} = [\delta_{\mathrm{u,n}}^{\mathrm{b}}]_{\mathrm{n}=1}^{\mathrm{K}}$. In this instance, the total number of weights in the model is assumed to be K.

A partition ratio p is determined based on the degree of data compression performed. P is the number of partitions included in the weight, and it can be understood that a compression ratio increases as p increases. In this instance, S is not necessarily a multiple of p. For convenience, if S is not a multiple of p, $\bar{\mathrm{S}} = \max\{s \in \mathbb{N}_S | (s)_{\mathrm{p}} = 0\}$ may be used for value representation and may be discarded by S - $\bar{\mathrm{S}}$ - 1. Further, the discarded bits correspond to low significant bits, and the number of discarded bits is relatively small. Therefore, it will have a trivial effect on performance, and this can be seen as a sufficiently negligible level. $\tilde{\delta}_{\mathrm{u}}^{\mathrm{b}}$ and $\tilde{\delta}_{\mathrm{u,n}}^{\mathrm{b}}$ may be defined as a matrix and a column vector in which these trivial bits are removed, and may be expressed as in Equation 5 below.

【Equation 5】

$$\tilde{\boldsymbol{\delta}}_u^{\mathrm{b}} = [\tilde{\boldsymbol{\delta}}_{u,n}^{\mathrm{b}}]_{n=1}^{K} \text{ where } \tilde{\boldsymbol{\delta}}_{u,n}^{\mathrm{b}} = \boldsymbol{\delta}_{u,n}^{\mathrm{b}}[1:\bar{S}+1]$$

Further, $\tilde{\boldsymbol{\delta}}_{u,n}^{\mathrm{b}} = \left[\tilde{\delta}_{u,n}^{\mathrm{b}}[1], \tilde{\boldsymbol{\delta}}_{u,n}^{\mathrm{b,v}}\right]$ where $\tilde{\boldsymbol{\delta}}_{u,n}^{\mathrm{b,v}} = \boldsymbol{\delta}_{u,n}^{\mathrm{b}}[2:\bar{S}+1]$. If an output through data compression from an intermediate matrix and column vectors is $\tilde{\delta}_{\mathrm{u}}^{\mathrm{comp,b}} = [\tilde{\delta}_{\mathrm{u,n}}^{\mathrm{comp,b}}]_{\mathrm{n}=1}^{\mathrm{K}}$, $\tilde{\delta}_{\mathrm{u,n}}^{\mathrm{comp,b}}$ is shown as Equation 6 below.

【Equation 6】

$$\tilde{\boldsymbol{\delta}}_{u,n}^{\mathrm{comp,b}} = [\underbrace{\tilde{\delta}_{u,n}^{\mathrm{b}}[1]}_{\text{sign}}, \underbrace{\tau_{\mathrm{us}}^{\mathrm{s2b}}(g, \lceil log_2(p) \rceil)}_{\text{partition indicator}}, \underbrace{\tilde{\boldsymbol{\delta}}_{u,n}^{\mathrm{b,v}}[(g-1)\frac{|\tilde{\boldsymbol{\delta}}_{u,n}^{\mathrm{b,v}}|}{p} + 1 : g\frac{|\tilde{\boldsymbol{\delta}}_{u,n}^{\mathrm{b,v}}|}{p}]}_{\text{partial value}}]$$

Here,

$$g = \lceil \mathbb{I}(\tilde{\boldsymbol{\delta}}_{u,n}^{\mathrm{b,v}})p / |\tilde{\boldsymbol{\delta}}_{u,n}^{\mathrm{b,v}}| \rceil,$$

and $\mathbb{I}(\mathbf{a})$ means a position in vector *a* where a bit with a value other than 0 first appears. If a is an all zero vector, a value at the last position is output as an output value. A result of performing a partition selection by detecting a position where 1 first appears is g. A partial value of a partition where 1 first appears has a most dominant influence on an actual gradient value.

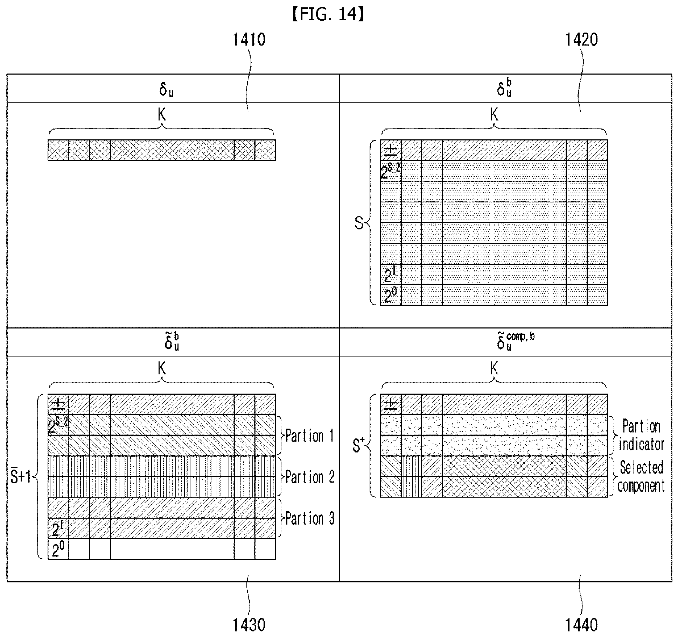

FIG. 14 illustrates an example of a process of performing a weight compression method.

Referring to FIG. 14, a UE obtains K weights as a result of learning (1410), and each of the obtained weights is converted to a binary form and expressed

(1420). Next, each weight converted to the binary form and expressed is partitioned and includes at least one partition (1430). Subsequently, for each of the partitioned weights, the UE detects a partition including a bit with a non-zero value that first exists in weight information and concatenates the partitions detected from the respective weights to generate compressed weight information. (1440).

As above, compressed data on which compression is performed is transmitted using a scalable Q-ary code in AirComp manner, and a receiver (server) side decodes an aggregated codeword and then performs a post-processing procedure. A post-processing method at the server side is described below.

**Post-processing**

The following describes a post-processing method at a server receiving local gradient/local parameter/local model/local weight (compressed based on an important-aware compression mode) from a plurality of UEs participating in federated learning.

When a binary sequence of an n-th codeword symbol decoded by the server is $\mathrm{c}_{\mathrm{n}}^{\mathrm{sys,b}}$, the server selects and concatenates each component from S* binary sequences $\mathrm{c}_{\mathrm{n}}^{\mathrm{sys,b}}$ and combines pieces of compressed local gradient/local parameter/local model/local weight information of each of devices. For example, the compressed local gradient/local parameter/local model/local weight of a specific device -u(device-u) participating in federated learning can be expressed as in Equation 7 below.

【Equation 7】

$$\hat{\boldsymbol{\delta}}_{u,k}^{\mathrm{comp,b}} = [\hat{c}_n^{\mathrm{sys,b}}[u]]_{n=S^*(k-1)+1}^{S^*k}$$

The server appropriately considers sign information, partition indexes, and partition values from the combined information, converts the compressed local gradient/local parameter/local model/local weight to a scalar value domain, and aggregates them to update a global model.

**Experiment Result**

The degree of compression based on an original weight bit sequence size S and a partition ratio p can be summarized as in Table 3 below.

[Table 3]

| *S* | ($p$, $\bar{S}$) | *S** | Compression ratio (*S*/*S**) |
|---|---|---|---|
| *S* = 8 | (2,6) | 5 | 1.6 |
| | (3,6) | 5 | 1.6 |
| *S* = 16 | (2,14) | 9 | 1.778 |
| | (3,15) | 8 | 2 |
| | (4,12) | 6 | 2.667 |
| | (5,15) | 5 | 3.2 |

According to Table 3 above, as p increases for a given S, it can be seen that the compression ratio generally tends to increase.

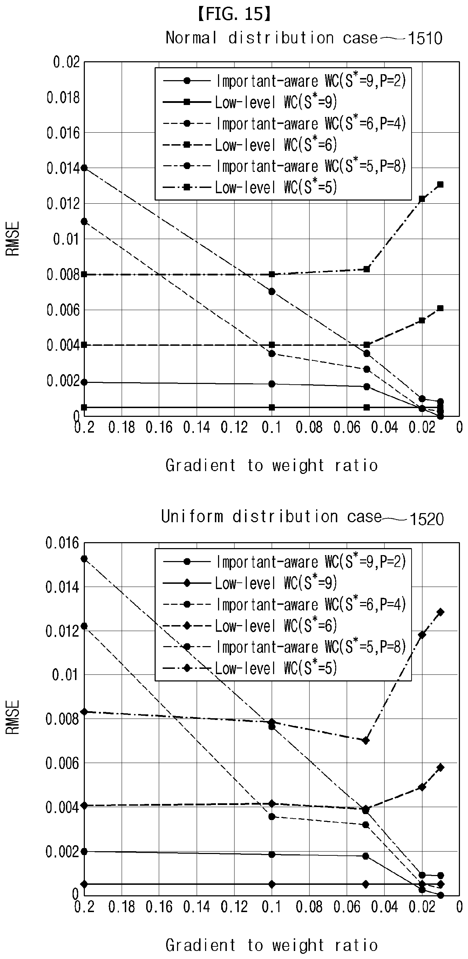

FIG. 15 illustrates a root mean square error for each compression type based on gradient to a weight ratio. More specifically, FIG. 15 illustrates that, assuming that a weight has a floating point between [-1, 1], a compression loss based on a gradient to weight ratio is expressed as a root mean square error (RMSE).

Referring to FIG. 15, the gradient to weight ratio (GWR) means a ratio of a local gradient distribution variance to a global weight distribution variance. It can be seen that the GWR is relatively high at the beginning of learning, and the GWR decreases as learning converges. Referring to FIG. 15, in terms of the compression loss, it can be seen that the simple low-level compression method is more efficient in an early stage of learning, and the important-aware compression method is more efficient after a mid-stage of learning (1510, 1520). An experiment result of FIG. 15 shows that the most efficient method at a specific learning round is applied in terms of the compression loss by selecting the suitable method among the low-level compression method and the important-aware compression method based on a difference between a global model value of a corresponding round and a global model value of a previous round and hybridly applying the selected method to learning.

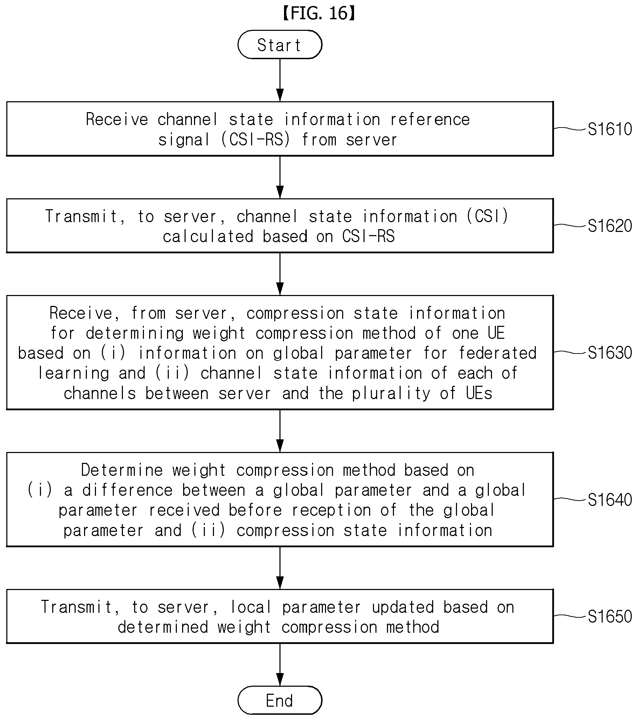

FIG. 16 is a flow chart illustrating an example of a method for a UE to perform federated learning in a wireless communication system described in the present disclosure.

More specifically, in a method for a plurality of UEs to perform a federated learning in a wireless communication system, one UE of the plurality of UEs receives a channel state information reference signal (CSI-RS) from a server, in S1610.

Next, the one UE transmits, to the server, channel state information (CSI) calculated based on the CSI-RS, in S1620.

Next, the one UE receives, from the server, compression state information for determining a weight compression method of the one UE based on (i) information on a global parameter for the federated learning and (ii) channel state information of each of channels between the server and the plurality of UEs, in S1630.

Subsequently, the one UE determines the weight compression method based on (i) a difference between the global parameter and a global parameter received before a reception of the global parameter and (ii) the compression state information, in S1640.

Finally, the one UE transmits, to the server, a local parameter updated based on the determined weight compression method in S1650.

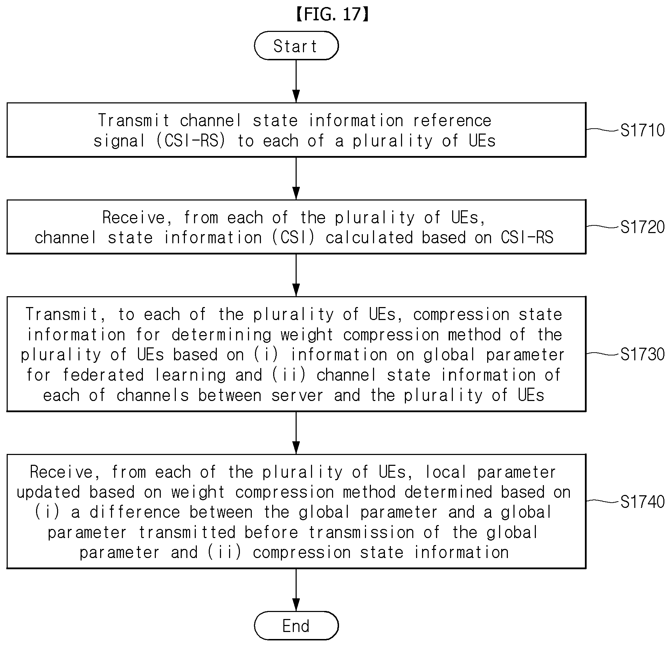

FIG. 17 is a flow chart illustrating an example of a method for a base station (server) to perform federated learning in a wireless communication system described in the present disclosure.

More specifically, in a method for a base station to perform a federated learning with a plurality of UEs in a wireless communication system, the base station transmits a channel state information reference signal (CSI-RS) to each of the plurality of UEs, in S1710.

Next, the base station receives, from each of the plurality of UEs, channel state information (CSI) calculated based on the CSI-RS, in S1720.

Subsequently, the base station transmits, to each of the plurality of UEs, compression state information for determining a weight compression method of the plurality of UEs based on (i) information on a global parameter for the federated learning and (ii) channel state information of each of channels between the server and the plurality of UEs, in S1730.

Finally, the base station receives, from each of the plurality of UEs, a local parameter updated based on the weight compression method determined based on (i) a difference between the global parameter and a global parameter transmitted before a transmission of the global parameter and (ii) the compression state information, in S1740.

## Device used in wireless communication system

Although not limited thereto, various proposals of the present disclosure described above can be applied to various fields requiring wireless communication/connection (e.g., 5G) between devices.

Hereinafter, a description will be given in more detail with reference to the drawings. In the following drawings/-description, the same reference numerals may denote the same or corresponding hardware blocks, software blocks, or functional blocks, unless otherwise stated.

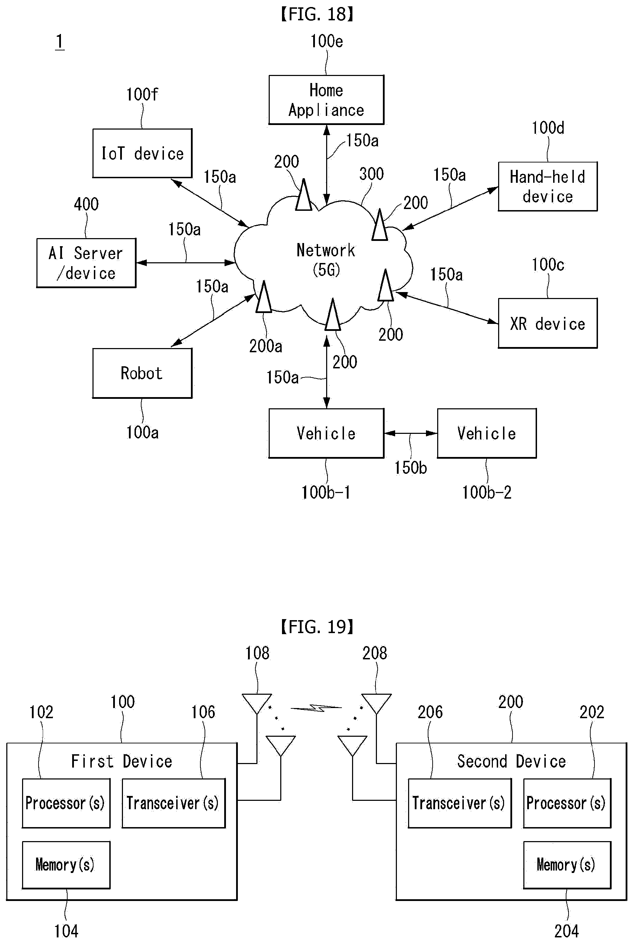

FIG. 18 illustrates a communication system 1 applied to various embodiments of the present disclosure.

Referring to FIG. 18, a communication system 1 applied to various embodiments of the present disclosure includes a wireless device, a base station, and a network. The wireless device may refer to a device that performs communication using a wireless access technology (e.g., 5G new RAT (NR) or long term evolution (LTE)) and may be referred to as a communication/wireless/5G device. The wireless device may include a robot 100a, vehicles 100b-1 and 100b-2, an eXtended Reality (XR) device 100c, a hand-held device 100d, a home appliance 100e, an Internet of Thing (IoT) device 100f, and an AI device/server 400, but is not limited thereto. For example, the vehicle may include a vehicle

with a wireless communication function, an autonomous vehicle, a vehicle capable of performing inter-vehicle communication, and the like. Further, the vehicle may include an unmanned aerial vehicle (UAV) (e.g., drone). The XR device may include an augmented reality (AR)/virtual reality (VR)/mixed reality (MR) device and may be implemented as a head-mounted device (HMD), a head-up display (HUD) provided in the vehicle, a television, a smart phone, a computer, a wearable device, a home appliance device, digital signage, a vehicle, a robot, etc. The hand-held device may include a smart phone, a smart pad, a wearable device (e.g., a smart watch, a smart glass), a computer (e.g., a notebook, etc.), and the like. The home appliance device may include a TV, a refrigerator, a washing machine, and the like. The IoT device may include a sensor, a smart meter, and the like. For example, the base station and the network may be implemented even as the wireless device, and a specific wireless device 200a may operate as a base station/network node for other wireless devices.

FIG. 19 illustrates a wireless device applicable to various embodiments of the present disclosure.

Referring to FIG. 19, a first wireless device 100 and a second wireless device 200 may transmit and receive radio signals through various wireless access technologies (e.g., LTE and NR). {The first wireless device 100 and the second wireless device 200} may correspond to {the wireless device 100x and the base station 200} and/or {the wireless device 100x and the wireless device 100x} of FIG. 19.

The first wireless device 100 may include one or more processors 102 and one or more memories 104 storing various information related to an operation of the one or more processors 102 and may further include one or more transceivers 106 and/or one or more antennas 108. The processor 102 may control the memory 104 and/or the transceiver 106 and may be configured to implement functions, procedures and/or methods described/proposed above.

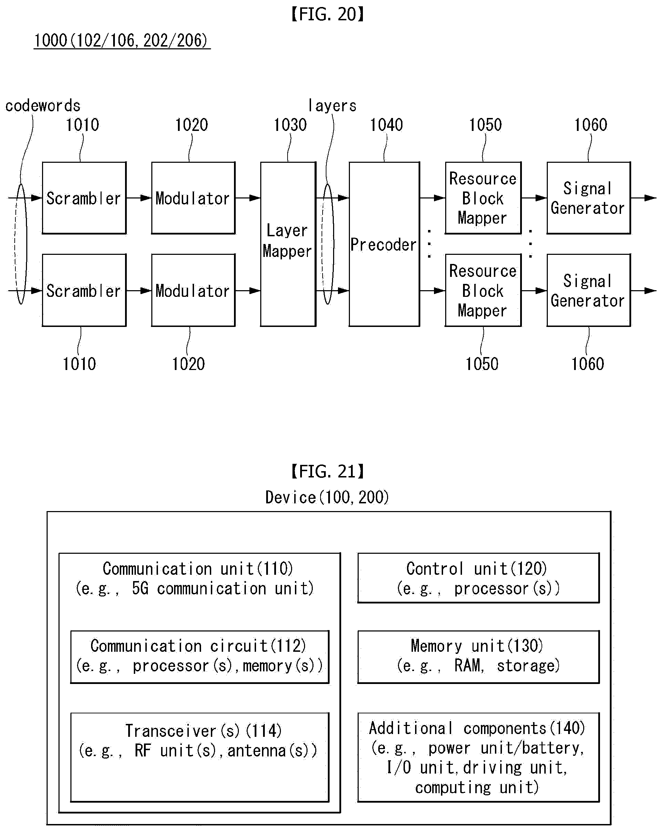

FIG. 20 illustrates a signal processing circuit for a transmission signal.

Referring to FIG. 20, a signal processing circuit 1000 may include scramblers 1010, modulators 1020, a layer mapper 1030, a precoder 1040, resource mappers 1050, and signal generators 1060. Although not limited to this, an operation/function of FIG. 20 may be performed by the processors 102 and 202 and/or the transceivers 106 and 206 of FIG. 19. Hardware elements of FIG. 20 may be implemented by the processors 102 and 202 and/or the transceivers 106 and 206 of FIG. 19. For example, blocks 1010 to 1060 may be implemented by the processors 102 and 202 of FIG. 19. Further, the blocks 1010 to 1050 may be implemented by the processors 102 and 202 of FIG. 19, and the block 1060 may be implemented by the transceivers 106 and 206 of FIG. 19.

Codewords may be converted into radio signals via the signal processing circuit 1000 of FIG. 20. The codewords are encoded bit sequences of information blocks. The information blocks may include transport blocks (e.g., a UL-SCH transport block, a DL-SCH transport block). The radio signals may be transmitted via various physical channels (e.g., PUSCH, PDSCH, etc.).

Specifically, the codewords may be converted into scrambled bit sequences by the scramblers 1010. Modulation symbols of each transport layer may be mapped (precoded) to corresponding antenna port(s) by the precoder 1040. Outputs z of the precoder 1040 may be obtained by multiplying outputs y of the layer mapper 1030 by an N*M precoding matrix W, where N is the number of antenna ports, and M is the number of transport layers. The precoder 1040 may perform precoding after performing transform precoding (e.g., DFT transform) for complex modulation symbols. Alternatively, the precoder 1040 may perform precoding without performing transform precoding. The resource mappers 1050 may map modulation symbols of each antenna port to time-frequency resources.

Signal processing procedures for a received signal in the wireless device may be configured in a reverse manner of the signal processing procedures 1010 to 1060 of FIG. 20.

FIG. 21 illustrates another example of a wireless device applied to various embodiments of the present disclosure. The wireless device may be implemented in various forms based on use cases/services.

Referring to FIG. 21, wireless devices 100 and 200 may correspond to the wireless devices 100 and 200 of FIG. 20 and may consist of various elements, components, units/portions, and/or modules. For example, each of the wireless devices 100 and 200 may include a communication unit 110, a control unit 120, a memory unit 130, and additional components 140. The communication unit may include a communication circuit 112 and transceiver(s) 114. For example, the control unit 120 may control an electric/mechanical operation of the wireless device based on programs/codes/instructions/information stored in the memory unit 130. The control unit 120 may transmit the information stored in the memory unit 130 to the exterior (e.g., other communication devices) through the communication unit 110 via a wireless/wired interface or store, in the memory unit 130, information received via the wireless/wired interface from the exterior (e.g., other communication devices) through the communication unit 110.

The additional components 140 may be variously configured based on types of wireless devices. For example, the additional components 140 may include at least one of a power unit/battery, input/output (I/O) unit, a driving unit, and a computing unit. The wireless device may be implemented in the form of the robot (100a of FIG. 18), the vehicles (100b-1 and 100b-2 of FIG. 18), the XR device (100c of FIG. 18), the hand-held device (100d of FIG. 18), the home appliance (100e of FIG. 18), the IoT device (100f of FIG. 18), a digital broadcast terminal, a hologram device, a public safety device, an MTC device, a medicine device, a fintech device (or a finance device), a security device, a climate/environment device, the AI server/device (400 of FIG. 18), the BSs (200 of FIG. 18), a network node, etc., but is not limited thereto. The wireless device

may be used in a mobile or fixed place based on a use-example/service.

Examples of implementation of FIG. 21 are described in more detail below.

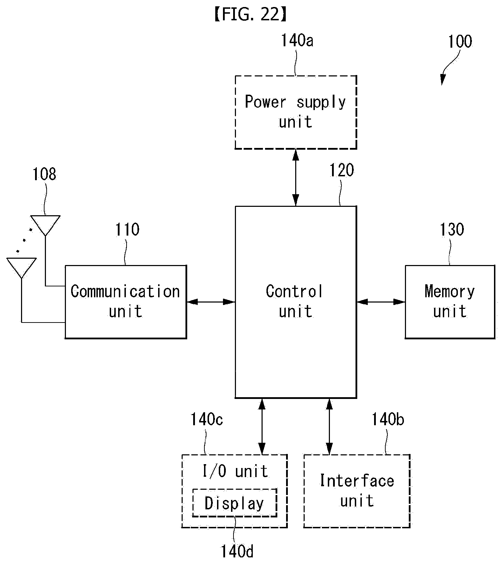

FIG. 22 illustrates a hand-held device applied to various embodiments of the present disclosure.

Referring to FIG. 22, a hand-held device 100 may include an antenna unit 108, a communication unit 110, a control unit 120, a memory unit 130, a power supply unit 140a, an interface unit 140b, and an I/O unit 140c. The antenna unit 108 may be configured as a part of the communication unit 110. Blocks 110 to 130/140a to140c correspond to the blocks 110 to 130/140 of FIG. 21, respectively.

The communication unit 110 may transmit and receive signals (e.g., data and control signals) to and from other wireless devices or BSs. The control unit 120 may perform various operations by controlling components of the hand-held device 100. The control unit 120 may include an application processor (AP). The memory unit 130 may store data/parameters/programs/codes/instructions needed to drive the hand-held device 100. The memory unit 130 may store input/output data/information. The power supply unit 140a may supply power to the hand-held device 100 and include a wired/wireless charging circuit, a battery, etc. The interface unit 140b may support connection of the hand-held device 100 to other external devices. The interface unit 140b may include various ports (e.g., an audio I/O port and a video I/O port) for connection with external devices. The I/O unit 140c may input or output video information/signals, audio information/signals, data, and/or information input by a user. The I/O unit 140c may include a camera, a microphone, a user input unit, a display unit 140d, a speaker, and/or a haptic module.

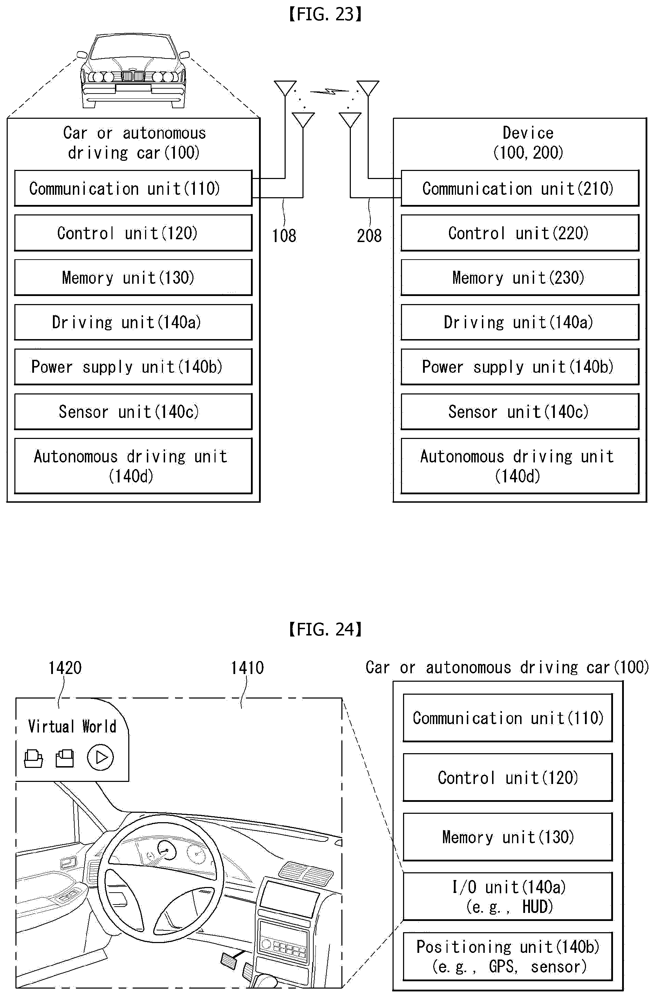

FIG. 23 illustrates a vehicle or an autonomous vehicle applied to various embodiments of the present disclosure. The vehicle or autonomous vehicle may be implemented by a mobile robot, a car, a train, a manned/unmanned Aerial Vehicle (AV), a ship, etc.

Referring to FIG. 23, a vehicle or autonomous vehicle 100 may include an antenna unit 108, a communication unit 110, a control unit 120, a driving unit 140a, a power supply unit 140b, a sensor unit 140c, and an autonomous driving unit 140d. The antenna unit 108 may be configured as a part of the communication unit 110. The blocks 110/130/140a to 140d correspond to the blocks 110/130/140 of FIG. 21, respectively.

The communication unit 110 may transmit and receive signals (e.g., data and control signals) to and from external devices such as other vehicles, BSs (e.g., gNBs and road side units), and servers. The control unit 120 may perform various operations by controlling elements of the vehicle or the autonomous vehicle 100. The control unit 120 may include an electronic control unit (ECU). The driving unit 140a may allow the vehicle or the autonomous vehicle 100 to drive on a road. The driving unit 140a may include an engine, a motor, a powertrain, a wheel, a brake, a steering device, etc. The power supply unit 140b may supply power to the vehicle or the autonomous vehicle 100 and include a wired/wireless charging circuit, a battery, etc. The sensor unit 140c, which may include various types of sensors, may obtain a vehicle state, ambient environment information, user information, etc. The autonomous driving unit 140d may implement technology for maintaining a lane on which a vehicle is driving, technology for automatically adjusting speed, such as adaptive cruise control, technology for autonomously driving along a determined path, technology for driving by automatically setting a path if a destination is set, and the like.

FIG. 24 illustrates a vehicle applied to various embodiments of the present disclosure. The vehicle may be implemented as a transport means, a train, an aerial vehicle, a ship, etc.

Referring to FIG. 24, a vehicle 100 may include a communication unit 110, a control unit 120, a memory unit 130, an I/O unit 140a, and a positioning unit 140b. The blocks 110 to 130/140a and 140b correspond to blocks 110 to 130/140 of FIG. 21, respectively.

The communication unit 110 may transmit and receive signals (e.g., data and control signals) to and from external devices such as other vehicles or base stations. The control unit 120 may perform various operations by controlling components of the vehicle 100. The memory unit 130 may store data/parameters/programs/codes/instructions for supporting various functions of the vehicle 100. The I/O unit 140a may output an AR/VR object based on information within the memory unit 130. The I/O unit 140a may include an HUD. The positioning unit 140b may acquire location information of the vehicle 100. The location information may include absolute location information of the vehicle 100, location information of the vehicle 100 within a traveling lane, acceleration information, and location information of the vehicle 100 from a neighboring vehicle. The positioning unit 140b may include a GPS and various sensors.

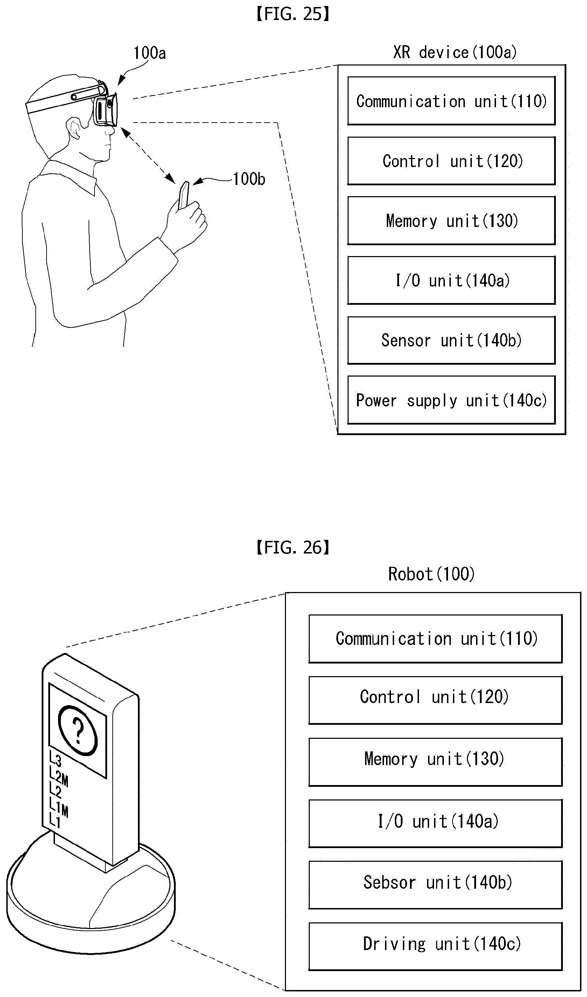

FIG. 25 illustrates an XR device applied to various embodiments of the present disclosure. The XR device may be implemented as an HMD, a head-up display (HUD) mounted in a vehicle, a television, a smartphone, a computer, a wearable device, a home appliance, a digital signage, a vehicle, a robot, etc.

Referring to FIG. 25, an XR device 100a may include a communication unit 110, a control unit 120, a memory unit 130, an I/O unit 140a, a sensor unit 140b, and a power supply unit 140c. The blocks 110 to 130/140a to 140c correspond to the blocks 110 to 130/140 of FIG. 21, respectively.

The communication unit 110 may transmit and receive signals (e.g., media data, control signal, etc.) to and from external devices such as other wireless devices, handheld devices, or media servers. The media data may include video, images, sound, etc. The control unit 120 may control components of the XR device 100a to perform various operations. For example, the control unit 120 may be configured to control and/or perform procedures such as video/image acquisition,

(video/image) encoding, and metadata generation and processing. The memory unit 120 may store data/parameters/programs/codes/instructions required to drive the XR device 100a/generate an XR object. The I/O unit 140a may obtain control information, data, etc. from the outside and output the generated XR object. The I/O unit 140a may include a camera, a microphone, a user input unit, a display, a speaker, and/or a haptic module. The sensor unit 140b may obtain a state, surrounding environment information, user information, etc. of the XR device 100a. The sensor 140b may include a proximity sensor, an illumination sensor, an acceleration sensor, a magnetic sensor, a gyro sensor, an inertial sensor, an RGB sensor, an IR sensor, a fingerprint scan sensor, an ultrasonic sensor, a light sensor, a microphone, and/or a radar. The power supply unit 140c may supply power to the XR device 100a and include a wired/wireless charging circuit, a battery, etc.

The XR device 100a may be wirelessly connected to the handheld device 100b through the communication unit 110, and the operation of the XR device 100a may be controlled by the handheld device 100b. For example, the handheld device 100b may operate as a controller of the XR device 100a. To this end, the XR device 100a may obtain 3D location information of the handheld device 100b and generate and output an XR object corresponding to the handheld device 100b.

FIG. 25 illustrates a robot applied to various embodiments of the present disclosure. The robot may be categorized into an industrial robot, a medical robot, a household robot, a military robot, etc., based on a used purpose or field.

Referring to FIG. 25, a robot 100 may include a communication unit 110, a control unit 120, a memory unit 130, an I/O unit 140a, a sensor unit 140b, and a power supply unit 140c. The blocks 110 to 130/140a to 140c correspond to the blocks 110 to 130/140 of FIG. 21, respectively.

The communication unit 110 may transmit and receive signals (e.g., driving information and control signals) to and from external devices such as other wireless devices, other robots, or control servers. The control unit 120 may perform various operations by controlling components of the robot 100. The memory unit 130 may store data/parameters/programs/codes/instructions for supporting various functions of the robot 100. The I/O unit 140a may obtain information from the outside of the robot 100 and output information to the outside of the robot 100. The I/O unit 140a may include a camera, a microphone, a user input unit, a display unit, a speaker, and/or a haptic module. The sensor unit 140b may obtain internal information of the robot 100, surrounding environment information, user information, etc. The sensor unit 140b may include a proximity sensor, an illumination sensor, an acceleration sensor, a magnetic sensor, a gyro sensor, an inertial sensor, an IR sensor, a fingerprint recognition sensor, an ultrasonic sensor, a light sensor, a microphone, a radar, etc. The driving unit 140c may perform various physical operations such as movement of robot joints. In addition, the driving unit 140c may allow the robot 100 to travel on the road or to fly. The driving unit 140c may include an actuator, a motor, a wheel, a brake, a propeller, etc.

FIG. 26 illustrates an AI device applied to various embodiments of the present disclosure. The AI device may be implemented as a fixed device or a mobile device, such as a TV, a projector, a smartphone, a PC, a notebook, a digital broadcast terminal, a tablet PC, a wearable device, a Set Top Box (STB), a radio, a washing machine, a refrigerator, a digital signage, a robot, a vehicle, etc.

Referring to FIG. 26, an AI device 100 may include a communication unit 110, a control unit 120, a memory unit 130, an input unit 140a, an out unit 140b, a learning processor unit 140c, and a sensor unit 140d. The blocks 110 to 130/140a to 140d correspond to the blocks 110 to 130/140 of FIG. 21, respectively.

The communication unit 110 may transmit and receive wired/radio signals (e.g., sensor information, user input, learning models, or control signals) to and from external devices such as other AI devices (e.g., 100x, 200, or 400 of FIG. 18) or an AI server 200 using wired/wireless communication technology. To this end, the communication unit 110 may transmit information within the memory unit 130 to an external device and transmit a signal received from the external device to the memory unit 130.

The control unit 120 may determine at least one feasible operation of the AI device 100, based on information which is determined or generated using a data analysis algorithm or a machine learning algorithm. The control unit 120 may perform an operation determined by controlling components of the AI device 100.

The memory unit 130 may store data for supporting various functions of the AI device 100.

The input unit 140a may acquire various types of data from the exterior of the AI device 100. The output unit 140b may generate output related to a visual, auditory, or tactile sense. The output unit 140b may include a display unit, a speaker, and/or a haptic module. The sensing unit 140 may obtain at least one of internal information of the AI device 100, surrounding environment information of the AI device 100, and user information, using various sensors. The sensor unit 140 may include a proximity sensor, an illumination sensor, an acceleration sensor, a magnetic sensor, a gyro sensor, an inertial sensor, an RGB sensor, an IR sensor, a fingerprint recognition sensor, an ultrasonic sensor, a light sensor, a microphone, and/or a radar.

The learning processor unit 140c may learn a model consisting of artificial neural networks, using learning data. The learning processor unit 140c may perform AI processing together with the learning processor unit of the AI server (400 of FIG. 18). The learning processor unit 140c may process information received from an external device through the

communication unit 110 and/or information stored in the memory unit 130. In addition, an output value of the learning processor unit 140c may be transmitted to the external device through the communication unit 110 and may be stored in the memory unit 130.

The embodiments described above are implemented by combinations of components and features of the present disclosure in predetermined forms. Each component or feature should be considered selectively unless specified separately. Each component or feature can be carried out without being combined with another component or feature. Moreover, some components and/or features are combined with each other and can implement embodiments of the present disclosure. The order of operations described in embodiments of the present disclosure can be changed. Some components or features of one embodiment may be included in another embodiment, or may be replaced by corresponding components or features of another embodiment. It is apparent that some claims referring to specific claims may be combined with another claims referring to the claims other than the specific claims to constitute the embodiment or add new claims by means of amendment after the application is filed.

Embodiments of the present disclosure can be implemented by various means, for example, hardware, firmware, software, or combinations thereof. When embodiments are implemented by hardware, one embodiment of the present disclosure can be implemented by one or more application specific integrated circuits (ASICs), digital signal processors (DSPs), digital signal processing devices (DSPDs), programmable logic devices (PLDs), field programmable gate arrays (FPGAs), processors, controllers, microcontrollers, microprocessors, and the like.

When embodiments are implemented by firmware or software, one embodiment of the present disclosure can be implemented by modules, procedures, functions, etc. performing functions or operations described above. Software code can be stored in a memory and can be driven by a processor. The memory is provided inside or outside the processor and can exchange data with the processor by various well-known means.

It is apparent to those skilled in the art that the present disclosure can be embodied in other specific forms without departing from essential features of the present disclosure. Accordingly, the above detailed description should not be construed as limiting in all aspects and should be considered as illustrative. The scope of the present disclosure should be determined by the appended claims.

[Industrial Applicability]

The present disclosure has described focusing on examples applying to the 3GPP LTE/LTE-A and the 5G system, but can be applied to various wireless communication systems in addition to the 3GPP LTE/LTE-A and the 5G system.

## Claims

**1.** A method for a plurality of user equipments, UEs, to perform a federated learning in a wireless communication system, the method performed by one UE of the plurality of UEs comprising:

receiving (S1610), from a server, a channel state information reference signal, CSI-RS;
transmitting (S1620), to the server, channel state information, CSI, calculated based on the CSI-RS;
receiving (S1630), from the server, compression state information for determining a weight compression method of the one UE based on (i) information on a global parameter for the federated learning and (ii) channel state information of each of channels between the server and the plurality of UEs;
determining (S1640) the weight compression method based on (i) a difference between the global parameter and a global parameter received before a reception of the global parameter and (ii) the compression state information; and
transmitting (S1650), to the server, a local parameter updated based on the determined weight compression method.

**2.** The method of claim 1, wherein determining the weight compression method is performed based on a result of comparison between (i) an average value of the difference between the global parameter and the global parameter received before the reception of the global parameter and (ii) a preset threshold for determining the weight compression method.

**3.** The method of claim 2, wherein, based on the average value of the difference between the global parameter and the global parameter received before the reception of the global parameter being greater than the preset threshold for determining the weight compression method, a first weight compression method is used.

4. The method of claim 3, wherein the first weight compression method is a method of generating a compressed weight based on each of at least one weight generated as a result of learning of the one UE being uniformly quantized to have a data resolution.

5. The method of claim 2, wherein, based on the average value of the difference between the global parameter and the global parameter received before the reception of the global parameter being less than the preset threshold for determining the weight compression method, a second weight compression method different from a first weight compression method is used.

6. The method of claim 5, wherein the second weight compression method is a method of generating a compressed weight based on, for each of at least one weight generated as a result of learning of the one UE, (i) a bit string constituting information included in each weight being partitioned to generate at least one partitioned weight, and (ii) a partition with a highest importance among the at least one partitioned weight being selected.

7. The method of claim 6, wherein, for each of the at least one weight generated as the result of learning of the one UE, each of the at least one partitioned weight is given a partition index.

8. The method of claim 7, wherein the compressed weight of each of the at least one weight generated as the result of learning of the one UE includes (i) information on a weight sign, (ii) partition weight information based on the partition with the highest importance selected among the at least one partitioned weight, and (iii) information on a partition index of the partition with the highest importance included in the partition weight information.

9. The method of claim 6, wherein the selected partition with the highest importance is a partition including a bit, that is first located among at least one bit with a non-zero value included in a weight including the selected partition with the highest importance within the weight including the selected partition with the highest importance.

10. The method of claim 9, wherein, based on values of all bits constituting a weight being zero, a partitioned weight last located among at least one partitioned weight included in the weight is included in the compressed weight.

11. A user equipment, UE, (100) performing a federated learning with a plurality of UEs in a wireless communication system, the UE (100) comprising:

a transmitter (106) configured to transmit a radio signal;
a receiver (106) configured to receive the radio signal;
at least one processor (102); and
at least one computer memory (104) operably connectable to the at least one processor,
wherein the at least one computer memory (104) is configured to store instructions performing operations based on being executed by the at least one processor (102),
wherein the operations comprise:

receiving, from a server, a channel state information reference signal, CSI-RS;
transmitting, to the server, channel state information, CSI, calculated based on the CSI-RS;
receiving, from the server, compression state information for determining a weight compression method of the one UE based on (i) information on a global parameter for the federated learning and (ii) channel state information of each of channels between the server and the plurality of UEs;
determining the weight compression method based on (i) a difference between the global parameter and a global parameter received before a reception of the global parameter and (ii) the compression state information; and
transmitting, to the server, a local parameter updated based on the determined weight compression method.

12. A method for a base station to perform a federated learning with a plurality of user equipments, UEs, in a wireless communication system, the method comprising:

transmitting (S1710), to each of the plurality of UEs, a channel state information reference signal, CSI-RS;
receiving (S1720), from each of the plurality of UEs, channel state information, CSI, calculated based on the CSI-RS;
transmitting (S1730), to each of the plurality of UEs, compression state information for determining a weight compression method of the plurality of UEs based on (i) information on a global parameter for the federated

learning and (ii) channel state information of each of channels between a server and the plurality of UEs; and receiving (S1740), from each of the plurality of UEs, a local parameter updated based on the weight compression method determined based on (i) a difference between the global parameter and a global parameter transmitted before a transmission of the global parameter and (ii) the compression state information.

**13.** A base station (200) performing a federated learning with a plurality of user equipments, UEs, in a wireless communication system, the base station (200) comprising:

a transmitter (206) configured to transmit a radio signal;
a receiver (206) configured to receive the radio signal;
at least one processor (202); and
at least one computer memory (204) operably connectable to the at least one processor (202),
wherein the at least one computer memory (204) is configured to store instructions performing operations based on being executed by the at least one processor,
wherein the operations comprise:

transmitting, to each of the plurality of UEs, a channel state information reference signal, CSI-RS;
receiving, from each of the plurality of UEs, channel state information, CSI, calculated based on the CSI-RS;
transmitting, to each of the plurality of UEs, compression state information for determining a weight compression method of the plurality of UEs based on (i) information on a global parameter for the federated learning and (ii) channel state information of each of channels between a server and the plurality of UEs; and
receiving, from each of the plurality of UEs, a local parameter updated based on the weight compression method determined based on (i) a difference between the global parameter and a global parameter transmitted before a transmission of the global parameter and (ii) the compression state information.

**14.** A non-transitory computer readable medium, CRM, storing one or more instructions,
wherein the one or more instructions executable by one or more processors are configured to allow a user equipment, UE, to:

receive, from a server, a channel state information reference signal, CSI-RS;
transmit, to the server, channel state information, CSI, calculated based on the CSI-RS;
receive, from the server, compression state information for determining a weight compression method of the UE based on (i) information on a global parameter for a federated learning and (ii) channel state information of each of channels between the server and a plurality of UEs;
determine the weight compression method based on (i) a difference between the global parameter and a global parameter received before a reception of the global parameter and (ii) the compression state information; and
transmit, to the server, a local parameter updated based on the determined weight compression method.

## Patentansprüche

**1.** Verfahren für eine Mehrzahl von Benutzergeräten, UEs, zur Durchführung eines föderierten Lernens in einem Drahtloskommunikationssystem, wobei das Verfahren, das von einem UE der Mehrzahl von UEs durchgeführt wird, Folgendes umfasst:

Empfangen (S1610), von einem Server, eines Kanalzustandsinformations-Referenzsignals, CSI-RS;
Senden (S1620), an den Server, von Kanalzustandsinformationen, CSI, die basierend auf dem CSI-RS berechnet wurden;
Empfangen (S1630), von dem Server, von Kompressionszustandsinformationen zum Bestimmen eines Gewichtskompressionsverfahrens des einen UEs basierend auf (i) Informationen über einen globalen Parameter für das föderierte Lernen und (ii) Kanalzustandsinformationen jedes von Kanälen zwischen dem Server und der Mehrzahl von UEs;
Bestimmen (S1640) des Gewichtskompressionsverfahrens basierend auf (i) einer Differenz zwischen dem globalen Parameter und einem vor einem Empfang des globalen Parameters empfangenen globalen Parameter und (ii) den Kompressionszustandsinformationen; und
Senden (S1650), an den Server, eines lokalen Parameters, der basierend auf dem bestimmten Gewichtskompressionsverfahren aktualisiert wurde.

2. Verfahren nach Anspruch 1, wobei das Bestimmen des Gewichtskompressionsverfahrens basierend auf einem Ergebnis eines Vergleichs zwischen (i) einem Durchschnittswert der Differenz zwischen dem globalen Parameter und dem vor dem Empfang des globalen Parameters empfangenen globalen Parameter und (ii) einem voreingestellten Schwellenwert zum Bestimmen des Gewichtskompressionsverfahrens durchgeführt wird.

3. Verfahren nach Anspruch 2, wobei, basierend darauf, dass der Durchschnittswert der Differenz zwischen dem globalen Parameter und dem vor dem Empfang des globalen Parameters empfangenen globalen Parameter größer als der voreingestellte Schwellenwert zum Bestimmen des Gewichtskompressionsverfahrens ist, ein erstes Gewichtskompressionsverfahren verwendet wird.

4. Verfahren nach Anspruch 3, wobei das erste Gewichtskompressionsverfahren ein Verfahren zum Erzeugen eines komprimierten Gewichts basierend darauf ist, dass jedes von mindestens einem Gewicht, das als ein Ergebnis des Lernens des einen UEs erzeugt wurde, gleichmäßig quantisiert wird, um eine Datenauflösung aufzuweisen.

5. Verfahren nach Anspruch 2, wobei, basierend darauf, dass der Durchschnittswert der Differenz zwischen dem globalen Parameter und dem vor dem Empfang des globalen Parameters empfangenen globalen Parameter kleiner als der voreingestellte Schwellenwert zum Bestimmen des Gewichtskompressionsverfahrens ist, ein zweites Gewichtskompressionsverfahren verwendet wird, das sich von einem ersten Gewichtskompressionsverfahren unterscheidet.

6. Verfahren nach Anspruch 5, wobei das zweite Gewichtskompressionsverfahren ein Verfahren zum Erzeugen eines komprimierten Gewichts ist, basierend darauf, dass für jedes von mindestens einem Gewicht, das als ein Ergebnis des Lernens des einen UEs erzeugt wurde, (i) eine Bitfolge, die in jedem Gewicht enthaltene Informationen bildet, partitioniert wird, um mindestens ein partitioniertes Gewicht zu erzeugen, und (ii) eine Partition mit einer höchsten Wichtigkeit aus dem mindestens einen partitionierten Gewicht ausgewählt wird.

7. Verfahren nach Anspruch 6, wobei für jedes des mindestens einen Gewichts, das als das Ergebnis des Lernens des einen UEs erzeugt wurde, jedem des mindestens einen partitionierten Gewichts ein Partitionsindex gegeben wird.

8. Verfahren nach Anspruch 7, wobei das komprimierte Gewicht von jedem des mindestens einen Gewichts, das als das Ergebnis des Lernens des einen UEs erzeugt wurde, (i) Informationen über ein Gewichtsvorzeichen, (ii) Partitionsgewichtsinformationen basierend auf der Partition mit der höchsten Wichtigkeit, die aus dem mindestens einen partitionierten Gewicht ausgewählt wurde, und (iii) Informationen über einen Partitionsindex der Partition mit der höchsten Wichtigkeit, die in den Partitionsgewichtsinformationen enthalten ist, umfasst.

9. Verfahren nach Anspruch 6, wobei die ausgewählte Partition mit der höchsten Wichtigkeit eine Partition ist, die ein Bit umfasst, das an erster Stelle unter mindestens einem Bit mit einem von Null verschiedenen Wert angeordnet ist, welches in einem Gewicht enthalten ist, das die ausgewählte Partition mit der höchsten Wichtigkeit umfasst, innerhalb des Gewichts, das die ausgewählte Partition mit der höchsten Wichtigkeit umfasst.

10. Verfahren nach Anspruch 9, wobei, basierend darauf, dass Werte aller ein Gewicht bildenden Bits Null sind, ein partitioniertes Gewicht, das an letzter Stelle unter mindestens einem in dem Gewicht enthaltenen partitionierten Gewicht angeordnet ist, in dem komprimierten Gewicht enthalten ist.

11. Benutzergerät, UE, (100), das ein föderiertes Lernen mit einer Mehrzahl von UEs in einem Drahtloskommunikationssystem durchführt, wobei das UE (100) Folgendes umfasst:

einen Sender (106), der dazu eingerichtet ist, ein Funksignal zu senden;
einen Empfänger (106), der dazu eingerichtet ist, das Funksignal zu empfangen;
mindestens einen Prozessor (102); und
mindestens einen Computerspeicher (104), der betriebsfähig mit dem mindestens einen Prozessor verbindbar ist,
wobei der mindestens eine Computerspeicher (104) dazu eingerichtet ist, Anweisungen zu speichern, die bei Ausführung durch den mindestens einen Prozessor (102) Operationen durchführen,
wobei die Operationen Folgendes umfassen:

Empfangen, von einem Server, eines Kanalzustandsinformations-Referenzsignals, CSI-RS;
Senden, an den Server, von Kanalzustandsinformationen, CSI, die basierend auf dem CSI-RS berechnet

wurden;
Empfangen, von dem Server, von Kompressionszustandsinformationen zum Bestimmen eines Gewichtskompressionsverfahrens des einen UEs basierend auf (i) Informationen über einen globalen Parameter für das föderierte Lernen und (ii) Kanalzustandsinformationen jedes von Kanälen zwischen dem Server und der Mehrzahl von UEs;
Bestimmen des Gewichtskompressionsverfahrens basierend auf (i) einer Differenz zwischen dem globalen Parameter und einem vor einem Empfang des globalen Parameters empfangenen globalen Parameter und (ii) den Kompressionszustandsinformationen; und
Senden, an den Server, eines lokalen Parameters, der basierend auf dem bestimmten Gewichtskompressionsverfahren aktualisiert wurde.

**12.** Verfahren für eine Basisstation zur Durchführung eines föderierten Lernens mit einer Mehrzahl von Benutzergeräten, UEs, in einem Drahtloskommunikationssystem, wobei das Verfahren Folgendes umfasst:

Senden (S1710), an jedes der Mehrzahl von UEs, eines Kanalzustandsinformations-Referenzsignals, CSI-RS;
Empfangen (S1720), von jedem der Mehrzahl von UEs, von Kanalzustandsinformationen, CSI, die basierend auf dem CSI-RS berechnet wurden;
Senden (S1730), an jedes der Mehrzahl von UEs, von Kompressionszustandsinformationen zum Bestimmen eines Gewichtskompressionsverfahrens der Mehrzahl von UEs basierend auf (i) Informationen über einen globalen Parameter für das föderierte Lernen und (ii) Kanalzustandsinformationen jedes von Kanälen zwischen einem Server und der Mehrzahl von UEs; und
Empfangen (S1740), von jedem der Mehrzahl von UEs, eines lokalen Parameters, der basierend auf dem Gewichtskompressionsverfahren aktualisiert wurde, das basierend auf (i) einer Differenz zwischen dem globalen Parameter und einem vor einer Übertragung des globalen Parameters gesendeten globalen Parameter und (ii) den Kompressionszustandsinformationen bestimmt wurde.

**13.** Basisstation (200), die ein föderiertes Lernen mit einer Mehrzahl von Benutzergeräten, UEs, in einem Drahtloskommunikationssystem durchführt, wobei die Basisstation (200) Folgendes umfasst:

einen Sender (206), der dazu eingerichtet ist, ein Funksignal zu senden;
einen Empfänger (206), der dazu eingerichtet ist, das Funksignal zu empfangen;
mindestens einen Prozessor (202); und
mindestens einen Computerspeicher (204), der betriebsfähig mit dem mindestens einen Prozessor (202) verbindbar ist,
wobei der mindestens eine Computerspeicher (204) dazu eingerichtet ist, Anweisungen zu speichern, die bei Ausführung durch den mindestens einen Prozessor Operationen durchführen,
wobei die Operationen Folgendes umfassen:

Senden, an jedes der Mehrzahl von UEs, eines Kanalzustandsinformations-Referenzsignals, CSI-RS;
Empfangen, von jedem der Mehrzahl von UEs, von Kanalzustandsinformationen, CSI, die basierend auf dem CSI-RS berechnet wurden;
Senden, an jedes der Mehrzahl von UEs, von Kompressionszustandsinformationen zum Bestimmen eines Gewichtskompressionsverfahrens der Mehrzahl von UEs basierend auf (i) Informationen über einen globalen Parameter für das föderierte Lernen und (ii) Kanalzustandsinformationen jedes von Kanälen zwischen einem Server und der Mehrzahl von UEs; und
Empfangen, von jedem der Mehrzahl von UEs, eines lokalen Parameters, der basierend auf dem Gewichtskompressionsverfahren aktualisiert wurde, das basierend auf (i) einer Differenz zwischen dem globalen Parameter und einem vor einer Übertragung des globalen Parameters gesendeten globalen Parameter und (ii) den Kompressionszustandsinformationen bestimmt wurde.

**14.** Nichtflüchtiges computerlesbares Medium, CRM, das eine oder mehrere Anweisungen speichert,
wobei die eine oder mehreren Anweisungen, die von einem oder mehreren Prozessoren ausführbar sind, eingerichtet sind, um es einem Benutzergerät, UE, zu ermöglichen:

ein Kanalzustandsinformations-Referenzsignal, CSI-RS, von einem Server zu empfangen;
Kanalzustandsinformationen, CSI, die basierend auf dem CSI-RS berechnet wurden, an den Server zu senden;
von dem Server Kompressionszustandsinformationen zum Bestimmen eines Gewichtskompressionsverfahrens des UEs basierend auf (i) Informationen über einen globalen Parameter für ein föderiertes Lernen und (ii)

Kanalzustandsinformationen jedes von Kanälen zwischen dem Server und einer Mehrzahl von UEs zu empfangen;
das Gewichtskompressionsverfahren basierend auf (i) einer Differenz zwischen dem globalen Parameter und einem vor einem Empfang des globalen Parameters empfangenen globalen Parameter und (ii) den Kompressionszustandsinformationen zu bestimmen; und
einen lokalen Parameter, der basierend auf dem bestimmten Gewichtskompressionsverfahren aktualisiert wurde, an den Server zu senden.

## Revendications

**1.** Procédé permettant à une pluralité d'équipements utilisateurs, UE, d'effectuer un apprentissage fédéré dans un système de communication sans fil, le procédé étant mis en œuvre par l'un UE de la pluralité d'UE et comprenant:

la réception (S1610), en provenance d'un serveur, d'un signal de référence d'informations relatives à l'état de canal, CSI-RS;
la transmission (S1620) au serveur des informations relatives à l'état du canal, CSI, calculées à partir du CSI-RS;
la réception (S1630), en provenance du serveur, des informations sur l'état de compression permettant de déterminer une méthode de compression pondérée pour l'UE en question, sur la base (i) d'informations relatives à un paramètre global pour l'apprentissage fédéré et (ii) d'informations relatives à l'état de canal de chacun des canaux entre le serveur et la pluralité d'UE;
la détermination (S1640) de la méthode de compression pondérée en fonction (i) d'une différence entre le paramètre global et un paramètre global reçu avant la réception du paramètre global et (ii) des informations d'état de compression; et
la transmission (S1650), au serveur, d'un paramètre local mis à jour en fonction de la méthode de compression pondérée déterminée.

**2.** Procédé selon la revendication 1, dans lequel la détermination de la méthode de compression pondérée est effectuée sur la base du résultat d'une comparaison entre (i) une valeur moyenne de la différence entre le paramètre global et le paramètre global reçu avant la réception du paramètre global et (ii) un seuil prédéfini pour la détermination de la méthode de compression pondérée.

**3.** Procédé selon la revendication 2, dans lequel, si la valeur moyenne de la différence entre le paramètre global et le paramètre global reçu avant la réception du paramètre global est supérieure au seuil prédéfini pour déterminer la méthode de compression pondérée, une première méthode de compression des poids est utilisée.

**4.** Procédé selon la revendication 3, dans lequel la première méthode de compression pondérée consiste à générer un poids compressé sur la base de chacun de l'au moins un poids généré à la suite de l'apprentissage de l'UE concerné, quantifié de manière uniforme pour présenter une résolution de données.

**5.** Procédé selon la revendication 2, dans lequel, si la valeur moyenne de la différence entre le paramètre global et le paramètre global reçu avant la réception du paramètre global est inférieure au seuil prédéfini pour déterminer la méthode de compression pondérée, une seconde méthode de compression pondérée différente de la première méthode de compression pondérée est utilisée.

**6.** Procédé selon la revendication 5, dans lequel la seconde méthode de compression pondérée consiste à générer un poids compressé en se basant, pour chacun d'au moins un poids généré à la suite de l'apprentissage de l'UE concerné, (i) sur une chaîne de bits constituant des informations incluses dans chaque poids, qui est partitionnée pour générer au moins un poids partitionné, et (ii) sur la sélection de la partition présentant l'importance la plus élevée parmi l'au moins un poids partitionné.

**7.** Procédé selon la revendication 6, dans lequel, pour chacun de l'au moins un poids généré à la suite de l'apprentissage de l'UE concerné, on attribue un indice de partition à chacun de l'au moins un poids partitionné.

**8.** Procédé selon la revendication 7, dans lequel le poids compressé de chacun de l'au moins un poids généré à la suite de l'apprentissage de l'UE concerné comprend: (i) des informations sur le signe de poids, (ii) des informations de poids de partition basées sur la partition présentant l'importance la plus élevée sélectionnée parmi l'au moins un poids partitionné, et (iii) des informations sur un indice de partition de la partition présentant l'importance la plus élevée,

incluses dans les informations de poids de partition.

**9.** Procédé selon la revendication 6, dans lequel la partition sélectionnée présentant l'importance la plus élevée est une partition comprenant un bit qui est le premier parmi au moins un bit de valeur non nulle inclus dans un poids comprenant la partition sélectionnée présentant l'importance la plus élevée, au sein du poids comprenant la partition sélectionnée présentant l'importance la plus élevée.

**10.** Procédé selon la revendication 9, dans lequel, sur la base du fait que les valeurs de tous les bits constituant un poids sont égales à zéro, un poids partitionné situé en dernier parmi au moins un poids partitionné inclus dans le poids est inclus dans le poids compressé.

**11.** Équipement d'utilisateur (UE) (100) effectuant un apprentissage fédéré avec une pluralité d'UE dans un système de communication sans fil, l'UE (100) comprenant:

un émetteur (106, 32260) configuré pour émettre un signal radio;
un récepteur (106) configuré pour recevoir le signal radio;
au moins un processeur (102) ; et
au moins une mémoire de processeur (104) connectée fonctionnellement à l'au moins processeur,
dans lequel l'au moins une mémoire d'ordinateur (104) est configurée pour stocker des instructions exécutant des opérations en fonction de leur exécution par le au moins un processeur (102),
dans lequel les opérations comprennent:

la réception, en provenance d'un serveur, d'un signal de référence d'information d'état de canal, CSI-RS;
la transmission, au serveur, des informations sur l'état de canal, CSI, calculées sur la base du CSI-RS;
la réception, en provenance du serveur, des informations sur l'état de compression permettant de déterminer une méthode de compression pondérée pour l'UE en question, sur la base (i) d'informations relatives à un paramètre global pour l'apprentissage fédéré et (ii) d'informations relatives à l'état de canal de chacun des canaux entre le serveur et la pluralité d'UE;
la détermination de la méthode de compression pondérée en fonction (i) d'une différence entre le paramètre global et un paramètre global reçu avant la réception du paramètre global et (ii) des informations d'état de compression; et
la transmission, au serveur, d'un paramètre local mis à jour en fonction de la méthode de compression pondérée déterminée.

**12.** Procédé, pour une station de base, pour effectuer un apprentissage fédéré avec une pluralité d'équipements utilisateurs, UE, dans un système de communication sans fil, le procédé comprenant:

la transmission (S1710), à chacun de la pluralité des UE, du signal de référence d'informations relatives à l'état de canal, CSI-RS;
la réception (S1720), en provenance de chacun de la pluralité des UE, des informations relatives à l'état du canal, CSI, calculées à partir du CSI-RS;
la transmission (S1730), à chacun de la pluralité d'UE, des informations sur l'état de compression permettant de déterminer une méthode de compression pondérée de la pluralité des UE, sur la base (i) d'informations relatives à un paramètre global pour l'apprentissage fédéré et (ii) d'informations relatives à l'état de canal de chacun des canaux entre le serveur et la pluralité d'UE; et
la réception (S1740), en provenance de chacun de la pluralité des UE, d'un paramètre local mis à jour sur la base de la méthode de compression pondérée en fonction (i) d'une différence entre le paramètre global et un paramètre global reçu avant la transmission du paramètre global et (ii) des informations d'état de compression.

**13.** Station de base (200) destinée à effectuer un apprentissage fédéré avec une pluralité d'équipements utilisateurs, UE, dans un système de communication sans fil, la station de base (200) comprenant:

un émetteur (206, 32260) configuré pour émettre un signal radio;
un récepteur (206) configuré pour recevoir le signal radio;
au moins un processeur (202) ; et
au moins une mémoire de processeur (204) connectée fonctionnellement à l'au moins processeur (202),
dans lequel l'au moins une mémoire d'ordinateur (204) est configurée pour stocker des instructions exécutant des opérations en fonction de leur exécution par le au moins un processeur,

dans lequel les opérations comprennent:

la transmission, à chacun de la pluralité des UE, du signal de référence d'informations relatives à l'état de canal, CSI-RS;
la réception, en provenance de chacun de la pluralité d'UE, des informations sur l'état de canal, CSI, calculées sur la base du CSI-RS;
la transmission, à chacun de la pluralité d'UE, des informations sur l'état de compression permettant de déterminer une méthode de compression pondérée pour la pluralité d'UE, sur la base (i) d'informations relatives à un paramètre global pour l'apprentissage fédéré et (ii) d'informations relatives à l'état de canal de chacun des canaux entre le serveur et la pluralité d'UE; et
la réception, en provenance de chacun de la pluralité d'UE, d'un paramètre local mis à jour sur la base de la méthode de compression pondérée en fonction (i) d'une différence entre le paramètre global et un paramètre global reçu avant la transmission du paramètre global et (ii) des informations d'état de compression.

**14.** Support lisible par ordinateur non transitoire, CRM, stockant une ou plusieurs instructions,
dans lequel la ou les instructions exécutables par le ou les processeurs sont configurées pour permettre à un équipement utilisateur, UE, de:

recevoir, en provenance d'un serveur, d'un signal de référence d'information d'état de canal, CSI-RS;
transmettre, au serveur, des informations sur l'état de canal, CSI, calculées sur la base du CSI-RS;
recevoir, en provenance du serveur, des informations sur l'état de compression permettant de déterminer une méthode de compression pondérée pour l'UE en question, sur la base (i) d'informations relatives à un paramètre global pour l'apprentissage fédéré et (ii) d'informations relatives à l'état de canal de chacun des canaux entre le serveur et la pluralité d'UE;
déterminer la méthode de compression pondérée en fonction (i) d'une différence entre le paramètre global et un paramètre global reçu avant la réception du paramètre global et (ii) des informations d'état de compression; et
transmettre, au serveur, un paramètre local mis à jour en fonction de la méthode de compression pondérée déterminée.

【FIG. 1】

INITIAL CELL SEARCH
SYSTEM INFORMATION RECEPTION
RANDOM ACCESS PROCEDURE
GENERAL DL/UL Tx/Rx
P/S-SCH& [DLRS]& PBCH
PDCCH/ PDSCH (BCCH)
PRACH
PDCCH/ PDSCH
PRACH
PDCCH/ PDSCH
PDCCH/ PDSCH
PUSCH/ PUCCH
S11
S12
S13
S14
S15
S16
S17
S18
· DL/UL ACK/NACK
· UE CQI/PMI/RI REPORT USING PUSCH AND PUCCH

【FIG. 2】

sCell-APs
sCell-UE
Dense sCell-RAN
sCell-APs
sCell-APs
sCell-UE
Drone network
M2M & M2H communication
Five Senses
Touch
Smell
Taste
Hear
Sight
BCI and AI
SDN
virtual remote assistance
3D virtual cordination
New virtual world
3D Story virtualization
3D gaming
MR
AR
M-UE
Ground/satellite integration
eHealth remote monitoring
M-UE
Robotics & automation
UM MIMO BS
FSO communication
UAV BS
UE
Controller
UAV network
UM-MIMO BS
FSO backhaul
VLC
VR
Smart Home
Smart City
VLC
Autonomous vehicle
Underwater communication

【FIG. 3】

$x_0 = 1$
$x_1$
$x_2$
$x_d$
$w_0$
$w_1$
$w_2$
$w_d$
$\Sigma$
s
$\sigma(\cdot)$
+1
$x_1$
$x_2$
$x_d$
$z_i$


【FIG. 4】

Input Layer
Hidden Layer
Output Layer
+1
$x_1$
$x_2$
$x_i$
$x_d$
+1
$z_1$
$z_2$
$z_j$
$z_H$
$s_1$
$s_2$
$s_K$
Input-Hidden Weight $W^{d \times H}$
Hidden-Output Weight $W^{H \times K}$

【FIG. 5】

+1
X1
X2
Xd
S1
S2
SK

【FIG. 6】

Input Layer
Hidden Layer
Output Layer
Input-Hidden Weight W h×w×h×w
Hidden-Output Weight W h×w×h×w

【FIG. 7】

3×3
Filter
Weight
Product
Sum
Activation
Function
W 3×3
s
σ(·)

【FIG. 8】

Output
Layer
Hidden
Layer
Input
Layer
Hidden-Output
Weight
W H×K
Input-Hidden
Weight
W d×H, W H×H
+1
+1

【FIG. 9】

Time
Input Sequence
1
2
3
t
T
Time 1
Time 2
Time 3

【FIG. 10】

1010
1011
Edge device #1
1012
Edge device #2
1013
Edge device #3
1020
Edge server
1021
Σ
Offline aggregation
1022
$w = \frac{1}{K}\sum_{k=1}^{K} w_k$

【FIG. 11】

1110
1111
Edge device #1
1112
Edge device #2
1113
Edge device #3
1120
Edge server
1121
$w = \frac{1}{K}\sum_{k=1}^{K} w_k$

【FIG. 12】

1210
1220
highly significant
lowly significant
S
±

【FIG. 13】

1310
1320
Device K
Edge server
Broadcast model hyperparameter and compression state info.
S13010
Update local model parameter $w_k^s$ given data set $\{X_{k,m}\}$
S13020
Upload updated local model parameter($w_k^s$)
S13030
Update global model parameter $w_{ES}^{(1)}$
S13040
Round #1
Broadcast updated global model parameter ($w_{ES}^{(1)}$) and compression state info.
S13050
Update local model parameter $w_k$ given data set $\{X_{k,m}\}$
S13060
Compression strategy selection [Type and ratio] $\eta_{th} \geq mean(|w_{ES}^{(1)} - w_{ES}^{(0)}|_1)$
S13070
Compress local gradient ( $\delta_k \rightarrow \tilde{\delta}_k^{comp,b}$ )
S13080
Upload compressed local model gradient( $\tilde{\delta}_k^{comp,b}$ )
S13090
Update global model parameter $w_{ES}^{(2)}$
S13100
Round #2

【FIG. 14】

1410
1420
$\delta_u$
$\delta_u^b$
K
K
±
$2^{S_2}$
S
$2^1$
$2^0$
$\tilde{\delta}_u^b$
$\tilde{\delta}_u^{comp,b}$
K
K
±
$2^{S_2}$
Partion 1
$\bar{S}+1$
Partion 2
Partion 3
$2^1$
$2^0$
±
$S^+$
Partion indicator
Selected component
1430
1440

【FIG. 15】

Normal distribution case
1510
0.02
0.018
0.016
0.014
0.012
0.01
0.008
0.006
0.004
0.002
0
RMSE
Important-aware WC(S*=9,P=2)
Low-level WC(S*=9)
Important-aware WC(S*=6,P=4)
Low-level WC(S*=6)
Important-aware WC(S*=5,P=8)
Low-level WC(S*=5)
0.2 0.18 0.16 0.14 0.12 0.1 0.08 0.06 0.04 0.02 0
Gradient to weight ratio

Uniform distribution case
1520
0.016
0.014
0.012
0.01
0.008
0.006
0.004
0.002
0
RMSE
Important-aware WC(S*=9,P=2)
Low-level WC(S*=9)
Important-aware WC(S*=6,P=4)
Low-level WC(S*=6)
Important-aware WC(S*=5,P=8)
Low-level WC(S*=5)
0.2 0.18 0.16 0.14 0.12 0.1 0.08 0.06 0.04 0.02 0
Gradient to weight ratio

【FIG. 16】

Start
Receive channel state information reference signal (CSI-RS) from server
S1610
Transmit, to server, channel state information (CSI) calculated based on CSI-RS
S1620
Receive, from server, compression state information for determining weight compression method of one UE based on (i) information on global parameter for federated learning and (ii) channel state information of each of channels between server and the plurality of UEs
S1630
Determine weight compression method based on (i) a difference between a global parameter and a global parameter received before reception of the global parameter and (ii) compression state information
S1640
Transmit, to server, local parameter updated based on determined weight compression method
S1650
End

【FIG. 17】

Start
Transmit channel state information reference signal (CSI-RS) to each of a plurality of UEs
S1710
Receive, from each of the plurality of UEs, channel state information (CSI) calculated based on CSI-RS
S1720
Transmit, to each of the plurality of UEs, compression state information for determining weight compression method of the plurality of UEs based on (i) information on global parameter for federated learning and (ii) channel state information of each of channels between server and the plurality of UEs
S1730
Receive, from each of the plurality of UEs, local parameter updated based on weight compression method determined based on (i) a difference between the global parameter and a global parameter transmitted before transmission of the global parameter and (ii) compression state information
S1740
End

【FIG. 18】

1
100e
Home Appliance
100f
IoT device
100d
Hand-held device
150a
200
300
400
AI Server /device
Network (5G)
100c
XR device
200a
Robot
100a
Vehicle
Vehicle
150b
100b-1
100b-2

【FIG. 19】

108
208
102
100
106
206
200
202
First Device
Second Device
Processor(s)
Transceiver(s)
Transceiver(s)
Processor(s)
Memory(s)
Memory(s)
104
204

【FIG. 20】

1000(102/106, 202/206)

codewords
layers
1010
1020
1030
1040
1050
1060
Scrambler
Modulator
Layer Mapper
Precoder
Resource Block Mapper
Signal Generator
Scrambler
Modulator
Resource Block Mapper
Signal Generator
1010
1020
1050
1060

【FIG. 21】

Device(100, 200)

Communication unit(110)
(e.g., 5G communication unit)

Communication circuit(112)
(e.g., processor(s), memory(s))

Transceiver(s) (114)
(e.g., RF unit(s), antenna(s))

Control unit(120)
(e.g., processor(s))

Memory unit(130)
(e.g., RAM, storage)

Additional components(140)
(e.g., power unit/battery, I/O unit, driving unit, computing unit)

【FIG. 22】

140a
100
Power supply unit
108
120
110
130
Communication unit
Control unit
Memory unit
140c
140b
I/O unit
Display
Interface unit
140d

【FIG. 23】

Car or autonomous driving car(100)
Communication unit(110)
Control unit(120)
Memory unit(130)
Driving unit(140a)
Power supply unit(140b)
Sensor unit(140c)
Autonomous driving unit (140d)
108
208
Device (100, 200)
Communication unit(210)
Control unit(220)
Memory unit(230)
Driving unit(140a)
Power supply unit(140b)
Sensor unit(140c)
Autonomous driving unit (140d)

【FIG. 24】

1420
1410
Car or autonomous driving car(100)
Virtual World
Communication unit(110)
Control unit(120)
Memory unit(130)
I/O unit(140a) (e. g., HUD)
Positioning unit(140b) (e. g., GPS, sensor)

【FIG. 25】

100a
100b
XR device(100a)
Communication unit(110)
Control unit(120)
Memory unit(130)
I/O unit(140a)
Sensor unit(140b)
Power supply unit(140c)

【FIG. 26】

Robot(100)

Communication unit(110)

Control unit(120)

Memory unit(130)

I/O unit(140a)

Sebsor unit(140b)

Driving unit(140c)

L3
L2M
L2
L1M
L1

【FIG. 27】

100
120
110
Communication Unit
140a
Input Unit
140c
Learning Processor Unit
Control Unit
Memory Unit
130
Output Unit
140b
Sensing Unit
140d

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 2021097430 A1
- US 2021158167 A1


### Non-patent literature cited in the description


- **SRIKANTH CHANDAR et al.** *Communication Optimization in Large Scale Federated Learning using Autoencoder Compressed Weight Updates*
- **MOJTABA VAEZI et al.** *Cellular, Wide-Area, and Non-Terrestrial IoT: A Survey on 5G Advances and the Road Towards 6G*